(19) **Europäisches Patentamt European Patent Office Office européen des brevets**

(11) **EP 2 646 787 B1**

(12) **EUROPEAN PATENT SPECIFICATION**

(45) Date of publication and mention
of the grant of the patent:
**31.08.2016 Bulletin 2016/35**

(51) Int Cl.:
**G06F 17/50** (2006.01)  **G01M 7/00** (2006.01)
**G01H 1/00** (2006.01)  **G01M 5/00** (2006.01)

(21) Application number: **12715813.7**

(22) Date of filing: **13.03.2012**

(86) International application number:
**PCT/DK2012/000020**

(87) International publication number:
**WO 2012/130237 (04.10.2012 Gazette 2012/40)**

(54) **METHOD FOR IMPROVING DETERMINATION OF MODE SHAPES FOR A MECHANICAL STRUCTURE AND APPLICATIONS HEREOF**

VERFAHREN ZUR VERBESSERUNG DER BESTIMMUNG VON MODUSFORMEN FÜR EINE MECHANISCHE STRUKTUR UND ANWENDUNGEN DAVON

PROCÉDÉ PERMETTANT D'AMÉLIORER LA DÉTERMINATION DES FORMES DE MODES POUR UNE STRUCTURE MÉCANIQUE, ET APPLICATIONS ASSOCIÉES

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **30.03.2011 DK 201100234**

(43) Date of publication of application:
**09.10.2013 Bulletin 2013/41**

(73) Proprietor: **Aarhus Universitet**
**8000 Aarhus C (DK)**

(72) Inventor: **BRINCKER, Rune**
**8000 Aarhus C (DK)**

(74) Representative: **Plougmann Vingtoft a/s**
**Rued Langgaards Vej 8**
**2300 Copenhagen S (DK)**

(56) References cited:
**WO-A1-01/33182**

• **BUTLAND A ET AL: "A reduced order, test verified component mode synthesis approach for system modeling applications", MECHANICAL SYSTEMS AND SIGNAL PROCESSING, LONDON, GB, vol. 24, no. 4, 1 May 2010 (2010-05-01), pages 904-921, XP026979266, ISSN: 0888-3270 [retrieved on 2009-08-28]**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

## Description

The invention relates to a method for improving determination of mode shapes for a mechanical structure where each mode shape is a vector that consists of a number of components and each vector corresponds to a natural frequency of the structure where the method comprises the steps as disclosed in claim 1.

The invention also relates to applications of the method.

The invention will in the following be explained more fully with reference to the drawings, on which:

Fig. 1 shows a principle drawing of a wind turbine

Fig. 2 shows the placement of 15 sensors on a model of the main beam of a wind blade

Fig. 3 shows the first 5 mode shape calculated based on the measurements

Fig. 4 shows the first 5 mode shape calculated based on the measurements (top plot) together with the modified mode shapes shown in an expanded graphical representation (bottom plot)

Fig. 5A shows an example of a weight function for mass change

Fig. 5B shows an example of a weight function for stiffness change

Fig. 6A shows a measure of the best fit when the measure is calculated on the fitted DOF's

Fig. 6B shows a measure of the best fit when the measure is calculated on the non-fitted DOF's

Fig. 7 shows the placement of the sensors on the plate used in the considered example

Fig. 8A shows the first bending mode shape of the simulated plate example, to the left the experimental mode shape, to the right the FE mode shape

Fig. 8B shows the second bending mode shape of the simulated plate example, to the left the experimental mode shape, to the right the FE mode shape

Fig. 8C shows the third bending mode shape of the simulated plate example, to the left the experimental mode shape, to the right the FE mode shape

Fig. 8D shows the fourth bending mode shape of the simulated plate example, to the left the experimental mode shape, to the right the FE mode shape

Fig. 8E shows the fifth bending mode shape of the simulated plate example, to the left the experimental mode shape, to the right the FE mode shape

Fig. 9 shows fit measure calculated over active and deleted DOF's.

### Known technology

### Calculation of mode shapes based on measurements

Mode shapes can be calculated based on measurements from any structure that is vibrating due to natural and/or artificial excitation forces acting on the structure. The measurements are taken by recording signals from sensors attached to the structure in order to measure the dynamic response of the structure in selected points and directions.

If the excitation forces are controlled it is common to take the structure into a laboratory so that all conditions can be controlled. In this case the technology is often denoted as "experimental modal analysis" (EMA). In case of larger structures and/or in cases where the excitation forces cannot be controlled, the responses are recorded due to the natural or operating excitation forces and in this case the technology is often denoted as "operational modal analysis" (OMA).

The sensors can be any kind of sensors, for instance accelerometers, velocity meters, strain gauges etc. The excitation can be any kind of excitation, for instance a controlled excitation can consist of pulses or white noise introduced by loading devices like hammers and shakers, or in case of natural excitation it can be due to forces from wind, waves or traffic.

When the measured signals have been recorded the response of the structure is known as a function of time in the points and directions where the sensors are located. We will gather the $M$ measured responses in the column vector $y(t)$. The vector contains the signals from the sensors; that is the vector components $y_1(t), y_2(t) \cdots y_M(t)$ so that $y(t) = y_1(t), y_2(t) \cdots y_M(t)\}^T$. It is normal to denote each of the sensor signals as a measured "degree of freedom" (DOF) or as we shall say in the following, the components in the vector $y(t)$ are the active DOF's in the measurement.

From the measured response the modes of the structure can be estimated, each mode is described by its mode shape and the corresponding natural frequency and damping. The modes describe the limited number of different ways the structure can move in a free - i.e. unforced - vibration. For each mode the mode shape describes the way the structure can move in space. The mode shape calculated from measurements is gathered in a column vector $a$ with components describing the movement in the points and in the direction of the mounted sensors, thus the number of components in the mode shape equals the number of measured signals. The natural frequency is the frequency of the free vibration, and finally the damping ratio defines how fast the vibration dies out in a free vibration. Thus the natural frequency and damping ratio describes the way the structure can move in time and is denoted $f$ and $\zeta$ respectively. For each mode the quantities a, $f$ and $\zeta$ are denoted the modal parameters.

Measurements are limited to a frequency band due to the discrete time defined by the sampling rate. If the sampling time step is $\Delta t$ then the frequency band - also called the Nyquist band - goes from DC (frequency zero) to the Nyquist frequency $f_v = 1/(2\Delta t)$. Therefore from recorded measurement it is only possible to identify the limited number of modes lying in this frequency band. When the modes have been identified then it is normal to list the modal parameters ranked according to frequency like

$$(1.1) \qquad \begin{aligned} & f_1, f_2 \cdots \\ & \varsigma_1, \varsigma_2 \cdots \\ & \mathbf{a}_1, \mathbf{a}_2 \cdots \end{aligned}$$

where for any natural frequency in the list $f_n < f_{n+1}$. Thus $f_1$ is the lowest natural frequency in the considered frequency band and if $M$ modes are present in the frequency band then $f_M$ is the highest natural frequency identified in the frequency band.

WO 01/33182 A1 describes a method for modal testing of an object. The object is excited, and vibrations are measured by a number of sensors. A spectral density matrix function is determined. Individual modes are identified by means of Singular Value Decomposition, and from auto spectral densities of the individual modes, natural frequencies and damping ratios can be estimated.

The paper "A reduced order, test verified component mode synthesis approach for system modeling applications", A. Butland et al., Mechanical Systems and Signal Processing, London, GB, Vol. 24, No. 4, May 2010, pp. 904-921, ISSN: 0888-3270, describes use of frequency and shape information acquired from modal testing to update a reduced order finite element models using exact analytical model improvement techniques. The connection degrees of freedom are then rigidly constrained in the test verified, reduced order model to provide the boundary conditions necessary for constraint modes and fixed interface normal modes.

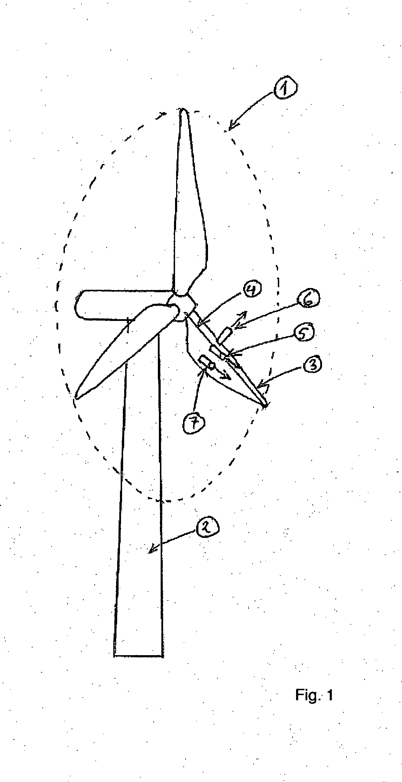

As an example of a case where measured signals are recorded from a mechanical structure we can consider the natural response of a wind turbine under operation, Figure 1. The wind turbine consist mainly of the rotor with three wind turbine blades (item 1), mounted on top of the tower (item 2). In this case the sensors used are accelerometers attached to one of the wind turbine blades (item 3) in a number of points along the axis of the blade (item 4). Some sensors (item 5) will normally be placed to measure the flap movement, i.e. the movement out of the rotor plane, some sensors (item 6) are measuring the edge movement, i.e. the movement in the rotor plane, and finally some sensors (item 7) are measuring flap movement away from the axis of the blade in order - together with sensors at the axis of the blade - to obtain information about the blade torsion.

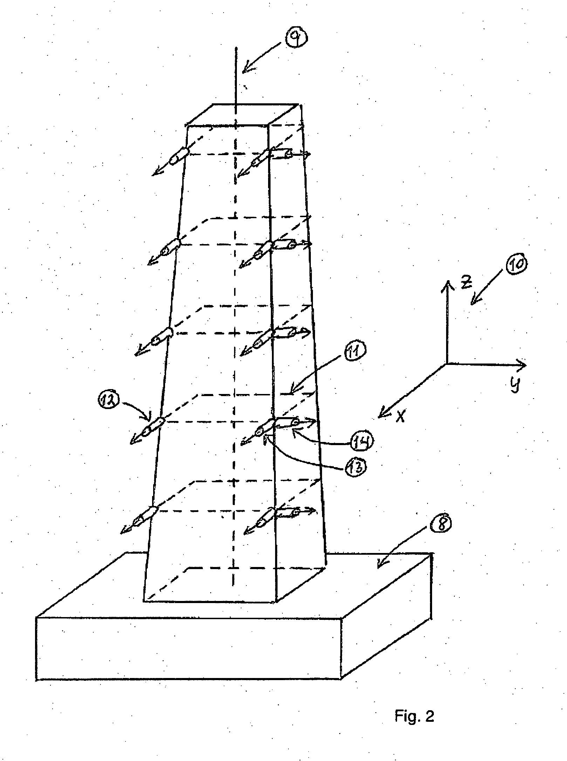

The whole wind turbine structure will have some modes related mainly to the tower, some related mainly to the rotor, and some mainly related to the blades. In this case when the sensors are mounted at one wind turbine blade, the measurements are mainly carried out to determine the modes in the blade itself. The local modes in the blade can also be studied by taking the blade - or the main beam inside the blade - into a testing facility (the lab) as shown in Figure 2. In this case the heavy end of the blade - that in Figure 1 is clamped into the rotor axis - is clamped into a stiff support (item 8) and the measurements are taken when loading the blade artificially.

In the example shown in Figure 2 the blade is mounted vertically, thus the beam axis (item 9) is parallel to the vertical axis z of the coordinate system (item 10), flap movement is parallel to the *x*-direction, and edge movement parallel to the *y*-direction of the coordinate system. In this case the measurements are taken at five different cross sections of the beam and we will consider the second cross section counted from the bottom (item 11). At the cross section two sensors (items 12 and 13) are measuring in the x-direction to be able to obtain information about the mode shape in the x-direction and information about the torsion, and one sensor is measuring in the *y*-direction (item 14). This secures that information about the mode shapes concerning both the flap movement, edge movement and torsional movement can be estimated.

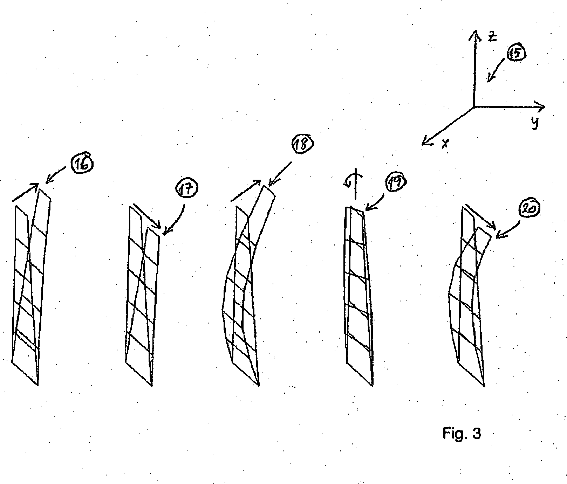

Mode shapes calculated from measurements taken on the mechanical structure shown in Figure 2 are shown in Figure 3. Also in this plot, the coordinate system (item 15) has the z-axis parallel to the axis of the beam, flap movement is in the x-direction and edge movement is in the *y*-direction. The first mode shape from the left is the first flap mode (item 16), the second from the left is the first edge mode (item 17), the third from the left is the second flap mode (item 18), the fourth from the left is first torsion mode (item 19) and finally the last mode shape from the left is the second edge mode (item 20).

*Calculation of mode shapes based on a simplified theoretical model*

Before a structure is made, normally a simplified theoretical model is formulated. Such model can be an analytical model formulated by hand on paper, however for simplicity we will think about the simplified model as a numerical model - normally a so-called finite element (FE) model - implemented in a computer program in its simplest form consisting of a mass matrix M and a stiffness matrix K , where the mass matrix describes the distribution of masses in the structure, and similarly the stiffness matrix describes the stiffness distribution in the structure.

Also for the computer model a scalar describing a movement somewhere in the computer model is denoted a DOF. If the total number of DOF's in the computer model is $N$ then the matrices **M** and **K** are both $N \times N$ symmetric matrices.

In the computer model the modes are found as the eigenvectors and eigenvalues to the matrix $\mathbf{M}^{-1}\mathbf{K}$, the eigenvectors are the mode shapes represented by the column vectors $\mathbf{b}_1, \mathbf{b}_2, \cdots$ and the square root of the eigenvalues are the natural frequencies. Since the natural frequencies for each mode are found from the eigenvalues the natural frequencies are also called the eigenfrequencies of the structure. A model like this has $N$ modes, i.e. $N$ mode shapes and $N$ corresponding natural frequencies.

Damping is usually not included in the model at this time because adding the damping does not significantly change the mode shapes and the natural frequencies, but the damping is normally added later when the model is used in order to get reasonable results in cases where the damping is important.

For modes calculated from a simplified theoretical model it is normal to list the modes according to frequency including only natural frequency and mode shapes

$$(1.2) \qquad \begin{aligned} f_1, f_2 \cdots \\ \mathbf{b}_1, \mathbf{b}_2 \cdots \end{aligned}$$

where for any natural frequency in the list $f_n < f_{n+1}$.

*Mode shape from a theoretical model corresponding a mode shapes calculated from measurements*

To compare mode shapes calculated from a theoretical model with mode shapes calculated from measurements, one can take the mode shapes from the model,

$$(1.3) \qquad \mathbf{b}_1, \mathbf{b}_2 \cdots$$

and remove the components in the vectors that does not correspond to a signal from one of the sensors in the measurements taken on the mechanical structure; we say that we reduce the mode shapes from the theoretical model to the DOF's active in the measurement, so that the so reduced vectors

$$(1.4) \qquad \mathbf{b}_{a1}, \mathbf{b}_{a2} \cdots$$

can be directly compared to the experimental mode shape vectors

$$(1.5) \qquad \mathbf{a}_1, \mathbf{a}_2 \cdots$$

because the components in the reduced vectors from the theoretical model correspond directly to the components in the mode shapes calculated from the measurements. Traditionally the mode shape vectors are compared by calculating the MAC value between one of the mode shapes a calculated from the measurements and all the mode shapes from the theoretical model $\mathbf{b}_{aj}$

$$(1.6) \qquad \mathrm{MAC}(\mathbf{a}, \mathbf{b}_{aj}) = \frac{(\mathbf{a}^T \mathbf{b}_{aj})^2}{(\mathbf{a}^T \mathbf{a})(\mathbf{b}_{aj}^T \mathbf{b}_{aj})}$$

The MAC value is a number between zero and one, the higher the value, the better the correlation between the two considered mode shapes, and thus, the more the two mode shapes are considered to be equal. Therefore, the mode shape b from the theoretical model that has the highest MAC value with a in its reduced set of components is denoted the corresponding mode shape from the theoretical model.

*Calculation of modified mode shapes*

It is commonly accepted that a mode shape a calculated from measurements can be approximated by a linear combination of modes from a theoretical model

$$(1.7) \qquad \begin{aligned} \mathbf{a} &\cong \mathbf{b}_{a1}t_1 + \mathbf{b}_{a2}t_1 + \cdots + \mathbf{b}_{aN}t_N \\ &\cong \mathbf{B}_a\mathbf{t} \end{aligned}$$

where we in this case have included all the modes from the model, we have written the series according to the ranking of the mode shapes after frequency in accordance with Eq. (1.2), we have used the reduced version of the mode shapes from the theoretical model as described in the preceding section and finally we have gathered all the mode shape vectors as columns in the matrix $\mathbf{B}_a = [b_{a1}, b_{a2} \dots b_{aN}]$ and all the coefficients $t_1, t_2, \cdots t_N$ in the column vector t= $\{t_1, t_2, \cdots t_N\}^T$.

If the number of components in the vectors - i.e. the number $M$ of signals from where the mode shape vector a is calculated - is equal to the number $N$ of modes, i.e. if $M = N$ then the matrix $\mathbf{B}_a$ is a square matrix and the set of coefficients can be found from Eq. (1.7) by simple inversion of the matrix

$$(1.8) \qquad \mathbf{t} \cong \mathbf{B}_a^{-1}\mathbf{a}$$

or if we accept the equal sign and thus define the estimate indicated by a hat

$$(1.9) \qquad \hat{\mathbf{t}} = \mathbf{B}_a^{-1}\mathbf{a}$$

If the number of modes from the theoretical model is smaller than the number of components in the mode shape vector, i.e. if $N < M$ , then a similar and meaningful approximate solution can be found as

$$(1.10) \qquad \hat{\mathbf{t}} = \mathbf{B}_a^{+}\mathbf{a}$$

where $\mathbf{B}_a^{+}$ is known as the pseudo inverse of $\mathbf{B}_a$. In both cases the modified mode shape is given by

$$(1.11) \qquad \hat{\mathbf{a}}_a = \mathbf{B}_a\hat{\mathbf{t}}$$

Meaningful solutions like Eq. (1.9) and (1.10) does not exist in cases where $N > M$. Therefore, if a large number of modes from the theoretical model needs to be included such that $N > M$, then the number of signals in the measurement must be increased in order to increase the number of components in the mode shape vectors calculated from the measurements such that $N \leq M$.

As it appears from the above, since the coefficient vector $\hat{\mathbf{t}}$ is found as an approximate solution, the modified mode shape $\hat{\mathbf{a}}_a$ is also an approximate solution indicated by the hat symbol, and since the mode shape vectors in the matrix $\mathbf{B}_a$ have been reduced to the active DOF's so is the modified mode shape given by Eq. (1.11) indicated by the subscript "a" on the modified mode shape $\hat{\mathbf{a}}_a$. However, since the mode shapes in the matrix $\mathbf{B}_a$ can be expanded to full size simply by including all components in the mode shapes as they are known from the theoretical model, then the modified mode shape can also be known in all DOF's defined in the theoretical model because the same equation can be used as in Eq. (1.11)

$$(1.12) \qquad \hat{\mathbf{a}} = \mathbf{B}\hat{\mathbf{t}}$$

where all vectors the matrix B and therefore also the vector â in Eq. (1.12) now has all the components defined in the theoretical model.

## *Problems with the known technology*

The problems with the known technology is two-fold

1. There are problems finding good estimates for the modified mode shapes
2. The bad estimates of the modified mode shapes makes it difficult to use these estimates in applications

*Problems finding good estimates for the modified mode shapes*

As explained above, mode shapes are normally listed according to frequency, and thus the linear combination given by Eq. (1.7) will in known technology start with the mode shape with the lowest frequency, and then include the mode shapes for the higher frequencies.

It is known that in practice the summation must be truncated because the theoretical model includes many modes that are outside of the frequency band defined by the measurements and thus are not meaningful to be included in the linear combination. However some confusion exists concerning how many mode shapes and which mode shapes should be included in the linear combination. This issue is explained in more detail in the theoretical presentation later in this document, however it is enough for the present to conclude that no clear well-functioning algorithms are known to clarify the following key questions

- Which modes should be included

- How many should be included

And without a good answer to these two questions, the linear combination given by Eq. (1.7) cannot provide good estimates for the modified mode shapes that can be of importance in practical applications.

## *Difficulties using the modified mode shapes in applications*

Accurate estimates of the modified mode shapes is of high value in applications like

- Updating, that means adjusting the theoretical model to correspond more correctly to the mechanical structure
- Damage detection, that means using updating to find out if a structural change has occurred and if this is case, finding out about the location and the severity of that change
- Structural health monitoring (SHM), that means taking measurements on a regular basis using updating and damage detection to find out if something significantly has reduced the strength of the structure
- Operating deflection shapes, that means graphically illustrating the movements of the structure as it was moving when the measurements were recorded
- Stress/ strain estimation, that means estimating the stresses and/or the strains as a function of time in the mechanical structure when the measurements were recorded

However, since the modified mode shapes cannot be calculated with high accuracy using known technology the modified mode shapes are not used much in these applications.

## *The principles and advantages of the invention*

## *Defining which mode shapes to be included in the linear combination*

The invention uses the same linear combination as given by Eq. (1.7), but with an important exception, instead of starting the linear combination with the mode shape corresponding to the mode with the lowest frequency and then adding mode shapes with higher and higher natural frequency as it has been common in known technology, the linear combination only includes as defined in claim 1

*"a limited numberof the mode shapes* $b_1, b_2 \cdots$ *with frequencies around the frequency of the corresponding mode shape b* "

As it is defined in claim 2, the invention suggests that the summation starts with the corresponding mode shape adding the mode shapes one by one taking the modes first that has the smallest distance to the corresponding mode shape measured in terms of frequency. This is the local correspondence principle explained in detail in the theoretical explanation later in this document and as it is defined in claim 2, this principle defines the sequence of the mode shapes to be included in the linear combination.

However, since the summation must be truncated at some point, the second part of claim 2 defines how many modes from the sequence defined in the first part of claim 2 should be included in the linear combination.

As it is explained above, the aim is to improve the accuracy of the modified mode shapes defined earlier. Therefore a measure of the fit quality must be defined that in a single value can express the difference between the original mode shape a calculated from the measurements and the modified mode shape a so that the difference can be minimized and thus, the improvement can be maximized. It is well known from fitting theory, that in order to have a reliable measure of the fit quality such that over fitting is prevented, the measure must be based on some components in the vectors that are not included in the fitting procedure itself, this is explained in more detail in the following sections about the theory of the invention.

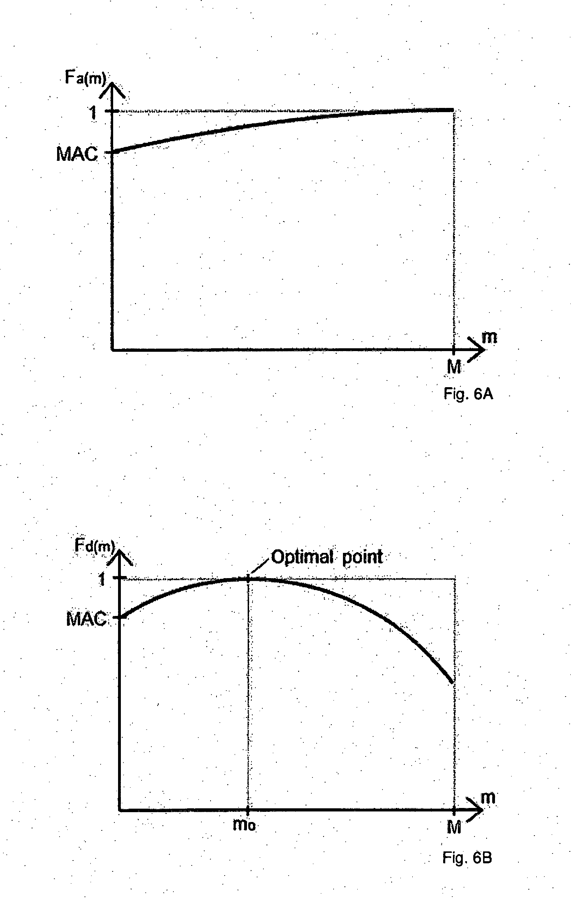

However, when a suitable measure of the fit quality has been established and if the fit quality is plotted as a function of the number of mode shapes included in the linear combination, then this plot shows a clear optimum as it is it appears from Figure 6B.

When the suitable measure of the fit quality has been established this principle can also be used to find the sequence of mode shapes to be included in the linear combination. Again the origin is the corresponding mode shape. However, when the next mode shape is included, instead of using the LC principle that defines the next mode to be included as the one with the smallest distance to the corresponding mode shape measured in terms of frequency, the fit quality can be used to find the next mode shape to be included according to

*"maximum fitting quality increment"*

as defined in claim 3. The principle of maximum fitting quality increment is most easily applied according to the following steps

1. Try to include all remaining mode shapes not yet included in the linear combination one-by-one
2. For each mode shape calculate the increment of the fit quality when the mode is included in the linear combination
3. Select the mode shape that gives the highest fit quality increment to be included as the next mode shape in the linear combination

This might give a slightly different result than using the LC principle directly, however the final result is always as described by claim 1 a linear combination consisting of "a *limited number of the mode shapes* $\mathbf{b}_1$, $\mathbf{b}_2$ ... *with frequencies around the frequency of the corresponding mode shape* $\mathbf{b}$"

### *Advantages of the invention*

The advantages of the invention include the following

- The accurately calculated modified mode shapes are improved mode shapes of the considered mechanical structure that can be expanded to all DOF's defined in the simplified theoretical model
- The accurately calculated modified mode shapes combine the advantage of calculating the mode shapes from the measurements (that the so calculated mode shapes are related to the considered mechanical structure) with the advantage of the simplified theoretical model (that the so calculated mode shapes are defined in an unlimited number of DOF's)
- The accurately calculated modified mode shapes do not have the disadvantage related to the mode shapes calculated from the measurements (that the so calculated mode shapes are limited to the set of components defined by the limited number of sensors) or to the disadvantage related to the simplified theoretical model (that the mode shapes are not representing the considered mechanical structure)

The reason why the modified mode shapes are improved versions of the mode shapes calculated from the measurement is that measurements always are influenced by random noise and measurement errors, and therefore, the mode shape vectors calculated from the measurement has errors on the components. A significant part of these errors are removed when the mode shapes are smoothed by using an optimal linear combination of mode shapes from the simplified theoretical model.

Experience shows that using accurately calculated modified mode shapes, unmeasured DOF's in the mode shapes can be calculated with the same accuracy or better than DOF's in the mode shapes calculated directly from the measurements.

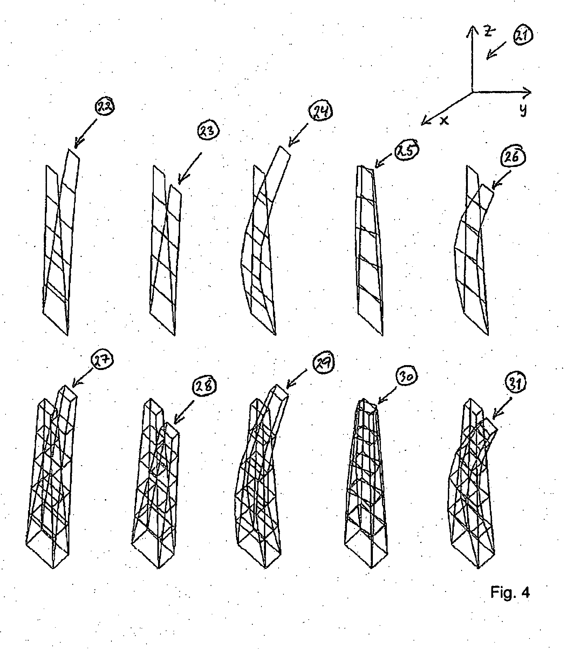

An example of using the accurately calculated modified mode shapes are shown in Figure 4. In Figure 4 it is illustrated how the mode shapes earlier shown in Figure 3 can be expanded and thus shown in more graphical detail using the invention. Also in Figure 4, the coordinate system (item 1) has the z -axis parallel to the axis of the beam, flap movement is in the *x* - direction and edge movement is in the *y*-direction.

In the top plots of Figure 4 the first 5 mode shapes calculated from measurements taken on the mechanical structure shown in Figure 2 are shown. The top plots of the Figure 4 shows the same mode shapes as the mode shapes shown in Figure 3. The first mode shape from the left is the first flap mode (item 22), the second from the left is the first edge mode (item 23), the third from the left is the second flap mode (item 24), the fourth from the left is first torsion mode (item 25) and finally the last mode shape from the left is the second edge mode (item 26). As explained earlier, at each of the five sections where the measurements are taken, three sensors are used, thus the mode shape vectors calculated from the measurements only have 15 vector components corresponding to the 15 sensors used.

In the bottom plots of Figure 4 the first 5 corresponding modified shapes calculated using an optimal linear combination of mode shapes from a theoretical model using the invention are shown. In order to known the full horizontal movement of all four corner points of each of the five considered cross sections, the mode shape vectors must be expanded to include the - components describing the movements in the x -direction and the *y* - direction of all four corner points of each cross section, thus for each cross section information about 8 vector components must be calculated, thus in total the modified mode shape vectors must be expanded to included 40 vector components corresponding to the 20 corner points of the considered cross sections.

The so expanded modified mode shape vectors are shown in the bottom plots of Figure 4. The first mode shape from the left is the first flap mode (item 27), the second from the left is the first edge mode (item 28), the third from the left is the second flap mode (item 29), the fourth from the left is first torsion mode (item 30) and finally the last mode shape from the left is the second edge mode (item 31).

As it appears from this example, the expanded modified mode shape is not only including more detailed information about the mode shapes of the mechanical structure, it also makes the graphics of the calculated mode shapes more realistic to look at.

In Figure 4 the coordinate system (item 21) is oriented like the coordinate system in Figures 2 and three, that is the x-axis is in the flap direction, and $\gamma$-direction is in the edge direction, and finally the z-axis is vertical and parallel to the beam axis of the considered specimen.

The invention furthermore comprises one or more of the following procedures for improvement of the determination of the modified mode shapes:

• the mode shapes included in the linear combination are defined by a sequence of the mode shapes of the theoretical model that starts with the corresponding mode shape b and where the remaining mode shapes are arranged in a sequence after the distance to the corresponding mode shape measured in term of frequency such that the mode shape with smallest distance measured in term of frequency to the corresponding mode shape has highest rank in the sequence.

• the number of mode shapes from this list that is to be included in the linear combination is determined by evaluating the fit quality that is a measure of the difference between the mode shape a and a calculated based on the vector components not included in the fitting algorithm and adjusting the number of included modes so that the fit quality is maximized.

• The mode shapes included in the linear combination are defined by a sequence of the mode shapes of the theoretical model that starts with the corresponding mode shape b and where the remaining mode shapes are arranged in a sequence according to maximum fitting measure increment, thus, the mode shape that comes first in the sequence gives the highest increment of the fitting quality when added to the linear combination, where the fitting quality is a measure of the difference between the mode shape a and â calculated based on the vectors components not included in the fitting algorithm and adjusting the number of included modes so that the fit quality is maximized.

• The modified shapes $\hat{\mathbf{a}}_1, \hat{\mathbf{a}}_2 \cdots$ that in the first place have been estimated in the set of components equaling the measured signals, are expanded to all components known in the simplified theoretical model by including all components of the mode shapes $\mathbf{b}_1, \mathbf{b}_2 \dots$ in the linear combination.

The invention furthermore comprises one or more of the following applications:

• Recording signals from a mechanical structure for the purpose of A: Calculation of stress/strain history and/or prediction of expected service life, B: calculation of structural changes such as damages resulting in loss of stiffness, C: Illustrating the time history of measured and/or unmeasured quantities that can be derived from the expanded set of modified mode shapes

- Application of the invention on structures like wind turbines, wave energy equipment, ships, airplanes, offshore structures, power plants, vehicles, rotating machinery, space structures, dams, bridges, buildings, tunnels.

*In order to understand the theory behind the invention, refer to the following:*

**Theory of the Principle of Local Correspondence**

It is well known that the correlation between experimental and finite element (FE) mode shapes is often relatively low, even for detailed models. The classical way of dealing with this problem is to perform an updating of the FE model to enhance the correlation between the two sets of mode shapes. However this is resource consuming and does not always lead to high quality results. This paper presents a simple way of modeling the experimental modes shapes as a linear combination of the FE mode shapes only including the mode shapes around (in terms of frequency) the corresponding FE mode shape, thus this principle is denoted "local correspondence" (LC). The principle is introduced based on the classical theory of eigenvector derivatives presented by Nelson and further developed by Heylen et al. A criterion is developed for determining the optimal number of modes to be included, and the principle is tested on a simple plate example. The example shows a clear improvement of the correlation between the modeled and the experimental mode shape. The LC principle can be used for accurate expansion of experimental mode shapes and response measurements to all degrees of freedom in the considered FE model, to quantify physical differences between the theoretical model and experiment and to scale experimental mode shapes using the FE model mass matrix.

Keywords: Experimental mode shape, FE mode shape, correspondence, linear combination, expansion, scaling

### Notation

| | |
|---|---|
| $y(t)$ | Response vector, analytical, numerical or experimental |
| $y_a(t), y_d(t)$ | Response vector of active and deleted DOF's |
| **M,K** | Mass and stiffness matrix |
| **T** | Transformation matrix |
| $\lambda$ | Eigenvalue |
| $\omega$ | Angular frequency (rad/s) |
| $\omega_i$ | Angular frequency of mode number m |
| $f$ | Frequency (in Hz) |
| $\zeta$ | Damping ratio |
| m | Modal mass |
| a | Experimental mode shapes (un-scaled) |
| $\alpha$ | Experimental mode shapes (scaled) |
| b | Model mode shapes (un-scaled) |
| $\beta$ | Model mode shapes (scaled) |
| $\mathbf{a}_a, \mathbf{b}_a, \alpha_a, \beta_a$ | Mode shapes in active DOF's |
| $\mathbf{a}_d, \mathbf{b}_d, \alpha_d, \beta_d$ | Mode shapes in deleted DOF's |
| $\mathbf{q}(t)$ | Modal coordinate vector |

### *1. Introduction*

The classical way to relate experimental and FE mode shapes is to compare the modes one-by-one, calculating the MAC value.

It is also well known that, even though serious effort has been put into a realistic modeling, often the correlation between the model and the experiment is relatively low. To improve correlation an updating procedure can be used. However this approach is often resource consuming and it does not always lead to satisfactory results.

In the literature, some commonly accepted procedures exist for relating experimental mode shapes with modes from a model, and further for expanding to the set of points in an FE model. SEREP is a well-known procedure for expansion and reduction of dynamic models that has been used also on experimental data, [14] (O'Callahan et al 1989), [3] (Avitabile et al 1989). However this technique just relates a single mode of the FE model to a single experimental mode. It is also known from structural modification theory that the exact correspondence between two dynamic models that exists in case of a complete set of mode shapes, [16] (Sestieri and D'Ambroggio 2001) can be used approximately when a limited number of modes are available. However, it does not seem that any accurate principle exists for selecting which modes should be included in the linear combination.

In the present paper a local correspondence (LC) principle is proposed to establish a linear relationship between unperturbed and perturbed mode shapes of a structure, in order to relate experimentally obtained mode shapes with modes determined by a finite element (FE) model. The aim of the LC principle is to formulate a simple way of establishing an accurate model of an experimentally obtained mode shape through a linear combination of a limited number of modes from an FE model. The FE model can be considered as a perturbation of the reality, i.e. it is not necessary accurate when comparing mode shapes one-by-one. However, when using a limited number of FE modes in a linear combination, a good approximation of the experimentally obtained mode shapes can be found. The main advantage of using this kind of approximation is that experimentally obtained mode shapes are smoothed, i.e. noise is removed from the experimental mode shape. Moreover, once the approximation is established over the set of measurement points, the same approximation, i.e. the same linear combination of FE modes, can be extended to all the points in the FE model, by using the full FE mode shapes.

In the paper it is also shown that, as long as the deviations between the two considered models are reasonably small, an approximate linear,relation always exists between a single experimental mode shape and a limited number of FE mode shapes. Moreover an optimal number of modes exist that provides an accurate approximation.

First the mentioned procedures from the literature are reviewed and analyzed for the their applicability to form a basis for modeling experimentally mode shapes and for expansion to a full set of coordinates. Then the theory of the LC principle is presented based on the work of Nelson, [13] and Heylen et al, [9], and finally the LC principle is illustrated on a simulated case where experimental mode shapes are modeled by mass perturbations of an ideal free-free plate with closely spaced modes. The example shows that the MAC value between the considered experimental modes and the modeled modes is improved from about 0.85 to 0.99 when passing from a single unperturbed mode shape (the classical case of comparing experiment and model) to a linear combination of several modes around the corresponding FE mode shape, as defined by the LC principle.

### 2. Related theories from the literature

The classical way to calculate the correlation between a mode shape **a** from an experiment and a mode shape bfrom a FE model is to calculate the MAC value [1] (Allemang 1982)

$$(2.1) \qquad \text{MAC}(i,j) = \frac{(\mathbf{a}_i^H \mathbf{b}_j)^2}{(\mathbf{a}_i^H \mathbf{a}_i)(\mathbf{b}_i^H \mathbf{b}_i)}$$

where the super index "H" means hermitian (transpose complex conjugate) - or if, we compare corresponding modes with a scaling to unit length

$$(2.2) \qquad \text{MAC}(i) = (\mathbf{a}_i^H \mathbf{b}_j)^2$$

Some improvement can be obtained when, due to structure symmetry, multiple or close modes exist. In this case a higher order MAC can be defined, [5] (D'Ambrogio and Fregolent 2003). It considers the correlation between an experimental/analytical modal vector and a subspace spanned by several analytical/experimental modal vectors, so that it can reconciliate sets of models shapes that are apparently not well correlated.

It is known, that for simple structures like single beam structures normally high MAC values are obtained between experimental modes and modes from the FE mode, [10] (Jaishi and Ren 2004), but for many practical structures with some degree of complexity, FE models gives relatively low MAC values in the range 0.8-0.9 for many modes, [18] (Wang, Li et al. 2010), [7] (Goge and Link 2003).

The classical solution to the discrepancy between experimental mode shapes and mode shapes from the model, is to correct the model by updating, [6] (Friswell and Mottershead 1995) and is often used in real cases where an accurate model is needed. However, it is known that updating the FE model will normally only remove some of the discrepancy between experimental modes and modes from the model. In many cases MAC values will only increase from 0.85 to 0.9-0.95, [18] (Wang, Li et al. 2010), [7] (Goge and Link 2003), [17] (Teughels and De Roeck 2004), [15] (Reynders, Teughels et al. 2010).

Some earlier attempts have been made to model the experimental modes by the FE modes instead of performing updating. SEREP (System Equivalent Reduction Expansion Process ), [14] (O'Callahan et al 1989) is based on the classical matrix formulation for any response y($t$)

$$(2.3) \qquad \mathbf{y}(t) = \mathbf{B}\mathbf{q}(t)$$

where $\mathbf{B}$ is a matrix holding the mode shapes $\mathbf{b}_i$ of the considered model and q($t$) is a vector holding the modal coordinates. Reducing the model to an active set of DOF's the total response can be expressed as a combination of the active and the deleted DOF's

$$(2.4) \qquad \mathbf{y}(t) = \begin{Bmatrix} \mathbf{y}_a(t) \\ \mathbf{y}_d(t) \end{Bmatrix} = \begin{bmatrix} \mathbf{B}_a \\ \mathbf{B}_d \end{bmatrix} \mathbf{q}(t)$$

and it can be shown that that the total response can be found from the observed response by

$$(2.5) \qquad \mathbf{y}(t) = \mathbf{T}\mathbf{y}_a(t)$$

where the transformation matrix T is found from

$$(2.6) \qquad \mathbf{B} = \mathbf{T}\mathbf{B}_a \Rightarrow \mathbf{T} = \mathbf{B}\mathbf{B}_a^+$$

Where $\mathbf{B}_a^+$ is the pseudo inverse of $\mathbf{B}_a$. The transformation matrix $\mathbf{T}$ can be used to transform the mass matrix and the stiffness matrix to the active set of DOF's without changing the mode shapes or the natural frequencies of the system. It should be noted that SEREP is focused on reduction and expansion of a model, and the transformation matrix is not directly related to experiments. Further, SEREP is relating all DOF's in the complete mode shape with the active set of DOF's. Note that the number of modes has to be the same, for instance considering only one mode in Eq. (2.6) we obtain

$$(2.7) \qquad \mathbf{b} = \mathbf{T}\mathbf{b}_a$$

SEREP has also been used to expand the measured DOF's in an experiment to all DOF's in a model, [3] (Avitabile et al 1989). In this case Eq. (2.6) is assumed to be valid also for the experimental mode shapes

$$(2.8) \qquad \mathbf{A} = \mathbf{T}\mathbf{A}_a$$

A similar idea has been mentioned by Brincker et al 2003, [4], where the modal coordinates for an experiment is found from Eq. (2.3) written for the experimental system

$$(2.9) \qquad \hat{\mathbf{q}}(t) = \mathbf{A}_a^+ \mathbf{y}_a(t)$$

Since the pseudo inverse is an estimate (it is assumed that the number of DOF's is larger than the number of modes), so is the modal coordinate, this is indicated by using a "^" on top of the modal coordinate. Thus the response in the active DOF's is estimated by

$$(2.10) \qquad \hat{\mathbf{y}}_a(t) = \mathbf{A}_a \hat{\mathbf{q}}(t)$$

and the response can then be modeled in all DOF's by expansion using for instance SEREP substituting Eq. (2.5) into Eq. (2.10)

$$(2.11) \qquad \mathbf{y}(t) = \mathbf{T}\mathbf{y}_a(t) = \mathbf{T}\mathbf{A}_a\hat{\mathbf{q}}(t)$$

In structural modification (SM), [16] (Sestieri and D'Ambroggio 2001), however, two models are considered, the unmodified and the modified structure. For convenience, here we denote the unmodified structure as "the FE model", and the modified structure as "the experiment" and use corresponding notation. In SM it is shown, that the mode shapes in the modified structure is a linear combination of the mode shapes of the unmodified structure, thus a transformation matrix $\mathbf{T}$ exist such that

$$(2.12) \qquad \mathbf{A} = \mathbf{B}\mathbf{T}$$

However in SM, such equation only holds exactly when a full set of modes is available, otherwise an approximate linear expansion must be used and modal truncation problems arise. In [6] (Friswell and Mottershead 1995) it is proposed, that Eq. (2.12) is used to smooth the experimental mode shapes and expand them to full size. Solving eq. (2.12) for the active set of DOF's

$$(2.13) \qquad \mathbf{A}_a = \mathbf{B}_a\mathbf{T} \Rightarrow \hat{\mathbf{T}} = \mathbf{B}_a^+\mathbf{A}_a$$

This solution provides only an estimate $\hat{\mathbf{T}}$ of $\mathbf{T}$ because the pseudo inverse is involved. However, the estimate has the quality of removing some of the noise by smoothing, thus the estimate

$$(2.14) \qquad \hat{\mathbf{A}}_a = \mathbf{B}_a\hat{\mathbf{T}}$$

has reduced noise, and the smoothed mode shapes can be expanded by using the full set of DOF's

$$(2.15) \qquad \hat{\mathbf{A}} = \mathbf{B}\hat{\mathbf{T}}$$

Friswell and Mottershead, [6] mention that only the modes that correlates well between the model and the measured data should be included (the modes with high MAC value). However using only the modes with high MAC values is in conflict with the main findings of the present paper.

Friswell and Mottershead, [6] also mention that this procedure is "very similar to SEREP". However it should be noted that this procedure differs from SEREP in some important points. SEREP relates only one mode in the experiment to one mode in the model as indicated by Eq. (2.7) whereas formula (2.15) relates one mode in the experiment to several modes in the model, for instance taking one mode in the experiment and all the modes from the model, Eq. (2.15) reads

$$(2.16) \qquad \hat{\mathbf{a}} = \mathbf{B}\hat{\mathbf{t}}$$

where $\hat{\mathbf{a}}$ and $\hat{\mathbf{t}}$ are the corresponding column vectors in the matrices $\mathbf{A}$ and $\hat{\mathbf{T}}$ respectively. Eq. (2.16) means that any mode shape in the experiment can be estimated by a linear combination of mode shapes from the model. Similar considerations has been introduced by Lipkens et al, [12].

Eq. (2.16) is the focus of the present paper. The intention is to show that this formula always holds with good approximation if the mode shapes in the matrix $\mathbf{B}$ include the mode that corresponds to the considered experimental mode shape and the mode shapes around it (in terms of frequency).

### 3. The local correspondence (LC) principle

The theory of mode shape sensitivity to changes in the mass and stiffness matrices are due to Nelson 1976, [13]. Nelson expressed the derivative of the mass normalized mode shape $\beta_i$ with respect to a certain parameter $u$ in the model as a linear combination of the undisturbed modes

$$(2.17) \qquad \frac{\partial \boldsymbol{\beta}_i}{\partial u} = \left[ \cdots \boldsymbol{\beta}_k, \boldsymbol{\beta}_{k+1} \cdots \right] \mathbf{c}$$

where the elements in the vector c are given by

$$(2.18) \qquad c_k = \frac{\boldsymbol{\beta}_k^T \mathbf{M} \mathbf{f}_i}{\lambda_k - \lambda_i} ; \quad i \neq k$$

where $\mathbf{M}$ is the mass matrix, thus $\boldsymbol{\beta}_k^T \mathbf{M}$ is the corresponding left eigenvector, $\lambda_k$ is the $k$th eigenvalue, and the vector $\mathbf{f}_i$ is given by

$$(2.19) \qquad \mathbf{f}_i = \boldsymbol{\beta}_i \left( \boldsymbol{\beta}_i^T \mathbf{M} \frac{\partial (\mathbf{M}^{-1} \mathbf{K})}{\partial u} \boldsymbol{\beta}_i \right) - \frac{\partial (\mathbf{M}^{-1} \mathbf{K})}{\partial u} \boldsymbol{\beta}_i$$

When Eq. (2.19) is inserted into Eq. (2.18) the first term of Eq. (2.19) disappear for $i \neq k$ due to mode shape orthogonality, thus

$$(2.20) \qquad c_k = - \frac{\boldsymbol{\beta}_k^T \mathbf{M} \dfrac{\partial (\mathbf{M}^{-1} \mathbf{K})}{\partial u} \boldsymbol{\beta}_i}{\lambda_k - \lambda_i} ; \quad i \neq k$$

From this evaluation of the term $c_k$ it is seen, that if the parameter $u$ is for instance one of the matrix elements in the stiffness matrix $\mathbf{K}$, then the derivative of the matrix is just a selection matrix, and the nominator of the fraction has a typical value that is of the order of $1/N$ where $N$ is the number of DOF's in then mode shapes. Thus the nominator has a numerical value that is approximately independent upon the combination of mode shapes, whereas the denominator obviously has a value that is decreasing the closer the expansion mode is to $\beta_i$ in, terms of frequency. Thus the term $c_k$ increases the closer the expansion *mode k* is to the considered mode i.

Nelson, [13] mentions that the expansion in Eq. (2.17) does not necessarily have to be complete, i.e. does not necessarily have to include all undisturbed modes, but can in principle be reduced to include a selected number of modes. However, it should be noted that Eq.(2.20) points to the fact that only the undisturbed modes around the considered disturbed mode needs to be included in the mode shape expansion given by Eq. (2.17).

This finding can be further developed based on the sensitivity analysis presented in Heylen et al (Heylen 1997). Following the ideas by Nelson, [13] presented above, Heylen et al, [1997] shows that making a perturbation of the parameter $u$ in a dynamic model leads to the following sensitivity on the undamped frequencies

$$(2.21) \qquad \frac{\partial \omega_i}{\partial u} = \frac{1}{2m_i} \mathbf{b}_i^T \left( - \omega_i \frac{\partial \mathbf{M}}{\partial u} + \frac{1}{\omega_i} \frac{\partial \mathbf{K}}{\partial u} \right) \mathbf{b}_i$$

and similarly, the sensitivity on the mode shapes is given by

$$(2.22) \qquad \frac{\partial \mathbf{b}_i}{\partial u} = - \frac{1}{2m_i} \mathbf{b}_i^T \frac{\partial \mathbf{M}}{\partial u} \mathbf{b}_i \mathbf{b}_i + \sum_{r=1, r \neq i}^{M} \frac{1}{\omega_i^2 - \omega_r^2} \frac{1}{m_r} \mathbf{b}_r^T \left( - \omega_i^2 \frac{\partial \mathbf{M}}{\partial u} + \frac{\partial \mathbf{K}}{\partial u} \right) \mathbf{b}_i \mathbf{b}_r$$

where $M$ is the number of modes in the model. In Eq. (2.21-22) it is assumed that mode shapes $\mathbf{b}_i$ are not mass normalized, thus the corresponding modal mass $m_i$ is given by

$$(2.23) \qquad m_i = \mathbf{b}_i^T \mathbf{M} \mathbf{b}_i$$

Now considering only a finite but small mass change $\Delta\mathbf{M}$, Eq. (2.21-22) reduce to the following approximate expression for the frequency change (exact for the mass change approaching zero)

$$(2.24) \qquad \Delta\omega_i \cong -\frac{\omega_i}{2m_i} \mathbf{b}_i^T \Delta\mathbf{M}\mathbf{b}_i$$

and similarly for the mode shape change

$$(2.25) \qquad \Delta\mathbf{b}_i \cong -\frac{1}{2m_i} \mathbf{b}_i^T \Delta\mathbf{M}\mathbf{b}_i\mathbf{b}_i - \sum_{r=1,r\neq i}^{M} \frac{1}{m_r} \frac{\omega_i^2}{\omega_i^2 - \omega_r^2} \mathbf{b}_r^T \Delta\mathbf{M}\mathbf{b}_i\mathbf{b}_r$$

The first term describes a scaling change of the considered mode shape, and the remaining terms describe the direction change. The first term can be considered as proportional to the inner product $\mathbf{b}_i^T \Delta\mathbf{M}\mathbf{b}_i$, but since the inner product is a scalar, the rightmost vector $\mathbf{b}_i$ can be removed to the front of the term, and thus the term can also be considered as proportional to the outer product $\mathbf{b}_i\mathbf{b}_i^T$. Following this idea on all terms in Eq. (2.25) the following matrix expression can be formed for the mode shape deviation

$$(2.26) \qquad \Delta\mathbf{b}_i \cong \mathbf{B}\mathbf{\Omega}_{M,i}\mathbf{B}^T \Delta\mathbf{M}\mathbf{b}_i$$

where the diagonal weighting matrix $\Omega_{M,i}$ for a mass change is given by

$$(2.27) \qquad \mathbf{\Omega}_{M,i} = \left[\Omega_r\right]_i = \begin{cases} \dfrac{-\omega_i^2}{m_r(\omega_i^2 - \omega_r^2)} & \text{for } r \neq i \\ -\dfrac{1}{2m_i} & \text{for } r = i \end{cases}$$

Therefore, since the elements in the diagonal matrix $\Omega_{M,i}$ only weight the modes close to $\mathbf{b}_i$ (note that the weights for the surrounding modes are approximately proportional to $\omega/(2\Delta\omega)$; $\Delta\omega = \omega_i - \omega_r$) then a limited set of modes with the truncated mode shape matrix $\mathbf{B}_i$ around the considered mode $\mathbf{b}_i$ (a mode shape cluster) can be selected such that

$$(2.28) \qquad \Delta\mathbf{b}_i \cong \mathbf{B}_i\mathbf{\Omega}_{M,i}\mathbf{B}_i^T \frac{\Delta\mathbf{M}}{m_i}\mathbf{b}_i$$

Therefore the corresponding deviated mode shape vector $\mathbf{a}_i$ is given by

$$(2.29) \qquad \mathbf{a}_i \cong \mathbf{b}_i + \mathbf{B}_i\mathbf{\Omega}_{M,i}\mathbf{B}_i^T \frac{\Delta\mathbf{M}}{m_i}\mathbf{b}_i$$

or in simplified form

$$(2.30) \qquad \mathbf{a}_i \cong \mathbf{b}_i + \mathbf{B}_i\mathbf{t}_i'; \quad \mathbf{t}_i' = \mathbf{\Omega}_{M,i}\mathbf{B}_i^T \frac{\Delta\mathbf{M}}{m_i}\mathbf{b}_i$$

Let us gather the deviated mode shape vectors in the matrix A= [$a_1$,$a_2$ ...], and let us form the unified matrix $\mathbf{B_0}$ of all the undisturbed modes needed to form a reasonable approximation of all the perturbed modes. Expanding the linear combination vectors $t'_k$ to include all modes in the matrix $\mathbf{B_0}$ and forming a matrix holding the linear combination vectors T' = [...,$t'_{i-1}$, $t'_1$,$t'_{i+1}$,···], we can expand Eq. (2.30) to cover all modes, thus

$$(2.31) \qquad \mathbf{A} \cong \mathbf{B} + \mathbf{B}_0 \mathbf{T}'$$

Now, since the mode shapes in **B** is a subset of the mode shapes in $\mathbf{B_0}$ we can define a truncated identity matrix **I'** such that **B =$\mathbf{B_0}$I'**, and thus

$$(2.32) \qquad \mathbf{A} \cong \mathbf{B} + \mathbf{B}_0 \mathbf{T}' = \mathbf{B}_0 (\mathbf{I}' + \mathbf{T}')$$

that for a small mass change finally proves the existence of the transformation

$$(2.33) \qquad \mathbf{A} \cong \mathbf{B}_0 \mathbf{T}$$

Where

$$(2.34) \qquad \mathbf{T} = \mathbf{I}' + \mathbf{T}'$$

This closes the proof concerning changes in the mass matrix. A special case occurs if we are considering only one perturbed mode, then

$$(2.35) \qquad \mathbf{a}_i \cong \mathbf{B}_i \mathbf{t}_i$$

Similarly if we consider a small but finite stiffness change ΔK, Eq. (2.21) and (2.22) reduce to the following approximate expression for the frequency change

$$(2.36) \qquad \Delta\omega_i = \frac{1}{2m_i\omega_i} \mathbf{b}_i^T \Delta\mathbf{K}\mathbf{b}_i$$

and similarly for the mode shape change

$$(2.37) \qquad \Delta\mathbf{b}_i \cong \frac{1}{m_i} \sum_{r=1,r\neq i}^{M} \frac{1}{\omega_i^2 - \omega_r^2} \mathbf{b}_r^T \Delta\mathbf{K}\mathbf{b}_i \mathbf{b}_r$$

and we can define the diagonal weighting matrix for a stiffness change

$$(2.38) \qquad \mathbf{\Omega}_{K,i} = \left[\Omega_r\right]_i = \begin{cases} \dfrac{1}{\omega_i^2 - \omega_r^2} & \text{for } r \neq i \\ 0 & \text{for } r = i \end{cases}$$

that is now rank deficient since the mode $b_i$ does not contribute for a stiffness change. However, exactly the similar arguments can be made as for the mass change, and thus again we arrive at an expression similar to Eq. (2.31), where now the linear transformation for a stiffness change is given by

$$(2.39) \qquad \mathbf{T}'_K = \left[\cdots, \mathbf{t}'_{i-1}, \mathbf{t}'_i, \mathbf{t}'_{i+1}, \cdots\right]_i \; ; \quad \mathbf{t}'_i = \frac{1}{m_i}\boldsymbol{\Omega}_{K,i}\mathbf{B}_i^T \Delta\mathbf{K}\mathbf{b}_i$$

Again we have defined a unified set of all the undisturbed modes needed to form a reasonable approximation of all the perturbed modes. Now, for the following taking the unified set as the largest of the unified sets for the mass change and for the stiffness change, for any combination of small mass and stiffness changes ΔM,ΔK an approximate linear relation exist such that

$$(2.40) \qquad \begin{aligned} \mathbf{A} &\cong \mathbf{B}_0\mathbf{T} \\ \mathbf{T} &= \mathbf{I}' + \mathbf{T}'_M + \mathbf{T}'_K \end{aligned}$$

where the column vectors in $\mathbf{T}'_M$ and $\mathbf{T}'_K$ are found by

$$(2.41) \qquad \begin{aligned} \mathbf{t}'_{M,i} &= \frac{1}{m_i}\boldsymbol{\Omega}_{M,i}\mathbf{B}_i^T\Delta\mathbf{M}\mathbf{b}_i \\[2mm] \mathbf{t}'_{K,i} &= \frac{1}{m_i}\boldsymbol{\Omega}_{K,i}\mathbf{B}_i^T\Delta\mathbf{K}\mathbf{b}_i \end{aligned}$$

It should be noted that the scaling of the t-vectors is not necessarily limited to the scaling defined by Eq. (2.41). Using another scaling of the t-vectors will just introduce the similar scaling on the α-vectors according to Eq. (2.40).Thus; different scaling can be used on the α-vectors and the b-vectors.

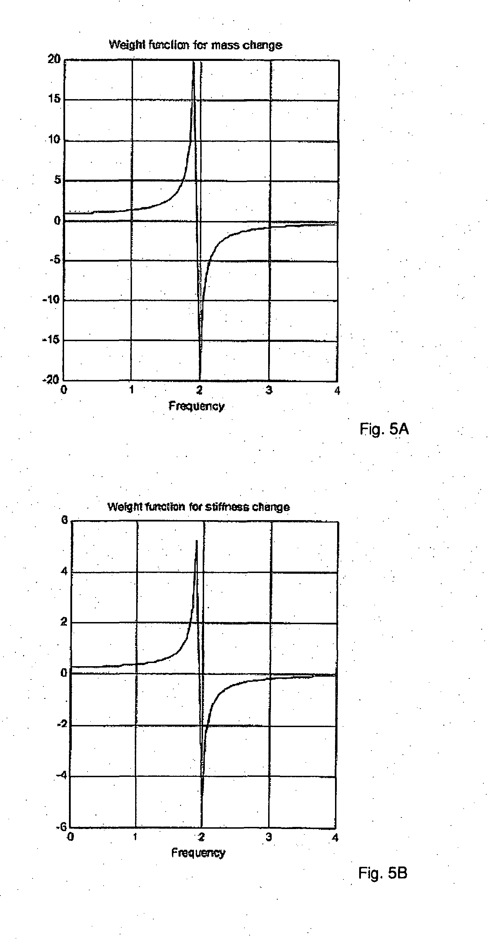

Examples of weight functions (terms in the diagonal matrices $\Omega_M$ and $\Omega_K$) are shown in Figure 5, in Figure 5A is shown an example of a weight function for a mass change, and in Figure 5B is shown an example of a weight function for a a stiffness change. In both Figure 5A and 5B the considered mode is assumed to be present at $\omega = 2$rad / s and that the remaining modes are equally spaced with a frequency separation of Δω = 0.05 rad / s between them.

As it appears, only the modes close to the considered mode contributes significantly. Note that modes towards DC always contribute to a certain degree (the weight approaches 1 for a mass change, and $1/\omega^2$ for a stiffness change). This means that modes close to DC are more easily modeled with high accuracy than modes higher in the frequency band. Further, note that since the weight factor for the mass has a relatively stronger weight on surrounding modes, a mass changes needs smaller number of modes than a stiffness change to yield the same accuracy.

In any case, for a mass perturbation, for a stiffness perturbation and for a combined perturbation of mass and stiffness, the perturbed modes can be written as given by Eq. (2.40) and the similar relation for a single mode is given by Eq. (2.35).

### 4. Criterion for choosing the optimal number of modes

In order to illustrate the challenge of defining a suitable measure of the best fit, let the measurement points be divided into two groups of points, the group of the active measurement points and the group of deleted measurement points. A considered experimental mode **a** is then known in the active DOF's defining $\mathbf{a_a}$, and in the deleted DOF's defining $\mathbf{a}_d$, the number of active DOF's is *M* .

Let us now consider the possible mode shape cluster matrices $\mathbf{B}_{a,1}, \mathbf{B}_{a,2} \cdots$ that can be used to form an estimate of the mode shape $\mathbf{a}_a$; the mode shape cluster matrix $\mathbf{B}_{a,1}$ including only one FE mode shape, the mode shape cluster matrix $\mathbf{B}_{a,2}$ including two FE mode shapes etc; and then, let us try to find out which mode shape cluster matrix is the best choice for the approximation given by Eq. (2.35).

For the considered experimental mode in the active DOF's $\mathbf{a}_a$ and for the *m* 'th cluster of FE modes $B_{a,m}$ (in the active DOF's) Eq. (2.35) can be solved

$$(2.42) \qquad \hat{\mathbf{t}}_m = \mathbf{B}_{a,m}^+\mathbf{a}_a$$

Note that the transformation vector will normally (number of DOF's is larger than that number of modes) be an estimate (marked by the hat) since we are using the pseudo inverse. The experimental mode shape can be estimated according to Eq. (2.35)

$$(2.43) \qquad \hat{\mathbf{a}}_{a,m} = \mathbf{B}_{a,m} \hat{\mathbf{t}}_m$$

A measure $F_a$ of the fit quality that depends upon the chosen mode shape cluster can then be found as the MAC value between the estimate $\hat{a}_{a,m}$ and the corresponding experimental mode shape $\mathbf{a}_a$. Assuming that $a_a$ is a unit vector we use Eq. (2.1)

$$(2.44) \qquad F_a(m) = \frac{(\hat{\mathbf{a}}_{a,m}^H \mathbf{a}_a)^2}{\hat{\mathbf{a}}_{a,m}^H \hat{\mathbf{a}}_{a,m}}$$

For the first mode shape cluster - i.e. only one FE mode shape included - it can be shown that the measure of fit $F_a$ $(m)$ = $F_a(1)$ is equal to the MAC value between the experimental mode shape and the corresponding FE mode shape (primary FE mode shape), see the later example. On the other hand, when the number $M$ of active DOF's is equal to the number of modes in the mode shape cluster matrix, i.e. when $m = M$ , then the matrix $B_{a,m}$ is square. In this case the pseudo inverse in Eq. (42) becomes equal to the inverse. Therefore the solution given by Eq. (2.43) is exact and thus, the fit is perfect, i.e. $F_a(M)$ =1. In between the two values $m$ = 1 and $m = M$, $F_a(m)$ will be increasing as shown in Figure 6A.

Therefore, since the measure $F_a(m)$ does not point to an optimal number of modes in between one and $M$ modes in the cluster of modes from the FE model, this measure is not valuable as a measure of the best fit. The reason is that when the number of modes $m$ approaches the number of modes $M$, then the errors on the active DOF's (the ones that are fitted) approaches zero, but the DOF's in between (the deleted DOF's) get large errors. This is especially true when noise is present on the experimental mode shape, which is always the case in practice. Therefore, a good measure of the quality of the fit should rather give an estimate of the errors on the deleted DOF's when the fit is performed on the active DOF's. Thus, a suitable measure of the quality of the fit is given by

$$(2.45) \qquad F_d(m) = \frac{(\hat{\mathbf{a}}_{d,m}^H \mathbf{a}_d)^2}{\hat{\mathbf{a}}_{d,m}^H \hat{\mathbf{a}}_{d,m}}$$

As before, for $m$ = 1 the measure $F_d(1)$ is equal to the MAC value (calculated over the deleted DOF's), but now the measure has a clear optimum as shown in the right plot of Figure 6B. The reason for the optimum is that for a small number of modes in the mode shape cluster, the fit increases as described by the LC principle as explained and proved above. However, when the number of modes becomes larger than what is really needed according to the LC principle then the experimental mode is "over fitted", and this will introduce excessive errors on the points that are not included in the fitting set (i.e. on the deleted points that constitute the set of points included in the considered error measure).

The measure $F_d(m)$ introduced above is an ideal measure because it reflects the errors on the un-fitted DOF's. Further, the measure reflects the correlation between the experiment mode shape **a** and the corresponding mode shape **â** modeled by the FE mode shapes. Therefore it measures how well the physics in the FE model reflects the physics of the experiment.

For a given set of measurement points, the division of the measurement points into the active and deleted DOF's can be performed in many ways, but it should be noted, that repeating the procedure several times, the deleted DOF's can be roved over the set of measurement points, so that at the end, all measurement points can be included in the best fit evaluation given by Eq. (2.45). For instance, we can assume that the measurement points are divided into two sets of equal size, the two sets can be swapped, the calculation procedure can be repeated, and the second time the other half of DOF's in the vectors $\hat{\mathbf{a}}_{d,m}, \mathbf{a}_d$ are estimated. Thus, in this case after just two steps, Eq. (2.45) can be calculated with vectors defined over the full set of measurement points.

As a results of using a best fit measure like the one given by Eq. (2.45), the optimal number of modes $m_0$ is estimated as the number of modes that provides the highest value of the best fit measure according to Eq. (2.45). Thus the experimental mode is now estimated by Eq. (2.43) for $m = m_0$

$$(2.46) \qquad \hat{\mathbf{a}}_{a,m_0} = \mathbf{B}_{a,m_0} \hat{\mathbf{t}}_{m_0}$$

where

$$(2.47) \qquad \hat{\mathbf{t}}_{m_0} \doteq \mathbf{B}^{+}_{a,m_0} \mathbf{a}_{a_0}$$

The estimate of the experimental mode shape $\hat{\mathbf{a}}_{m0}$ defined in all points is then obtained simply by defining the mode shape cluster matrix in all DOF's

$$(2.48) \qquad \hat{\mathbf{a}}_{m_0} = \mathbf{B}_{m_0} \hat{\mathbf{t}}_{m_0}$$

### 5. Example: modes of a plate with mass perfurbations

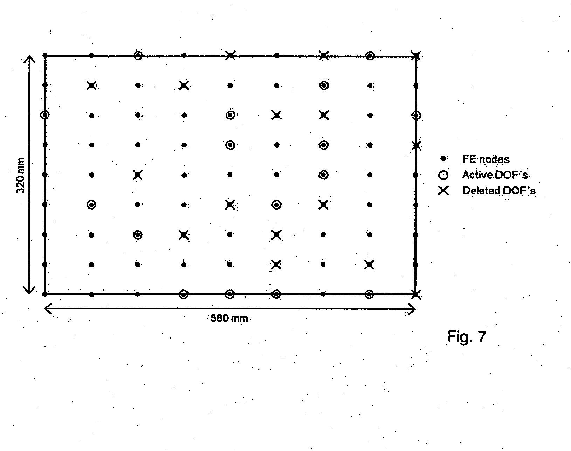

In the current example a steel version of the IES modal plate is considered, [8] (Gregory 1989). The plate measures 580x320x3 mm and is modeled with plate elements using 81 nodes. The nodes are placed in a 9x9 grid equally distributed over the plate, see Figure 7. Thus the FE model has 9x9=81 nodes - marked with dots in Figure 7.

Only out-of-plane translations are considered, thus the FE model of the plate has totally 81 DOF's. The active measurement DOF's are marked with a circle in Figure 7 and the deleted measurement DOF's are marked with a cross in Figure 7.

The boundary conditions of the plate are fixed in directions parallel to the plate. Perpendicular to the plate, the plate is basically free, but small springs are employed in order to avoid numerical difficulties solving the FE problem. Therefore, the plate has three rigid body modes close to DC. Only the translational DOF's perpendicular to the plate is considered, thus rotational DOF's are not included in the following analysis.

Therefore, for the considered plate one DOF is observed for each node, thus in total the plate has 81 DOF's. The measurement points are marked by the circles and crosses in Figure 7, 32 measurement points are used, 16 of the measurement points are chosen as the active DOF's (DOF's used for optimization - marked with a circle in Figure 7), and the remaining 16 measurement points are used as deleted DOF's (DOF's used to check the fit - marked with crosses in Figure 7). The 16 measurement points where chosen by a random permutation of the first 32 DOF's in the FE model.

Since we are considering in total 81 DOF's, the total number of modes (vibration modes perpendicular to the plate) in the problem is also 81. All 81 mode shapes- and their respective frequencies - are extracted from an FE program, in this case the commercial FE-program "Autodesk Robot Structural Analysis Professional 2011" was used, [2] (Autodesk 2011). The mass- and stiffness matrices were then created using the mass normalization equation $\mathbf{B}^{T}\mathbf{MB} = \mathbf{I}$ and the stiffness matrix counterpart $\mathbf{B}^{T}\mathbf{KB} = \left\lceil \omega_n^2 \right\rfloor$

$$(2.49) \qquad \mathbf{M} = \mathbf{B}^{-T}\mathbf{B}^{-1} ; \quad \mathbf{K} = \mathbf{B}^{-T}\left\lceil \omega_n^2 \right\rfloor \mathbf{B}^{-1}$$

This estimation introduces some minor errors on the matrix elements. These errors are dealt with by forcing all off-diagonal elements in the mass matrix to zero (the FE model is a lumped mass model), and forcing the stiffness matrix to be symmetric.

The mass matrix is then perturbed by a process where each matrix element $M_{rc}$ in the mass matrix is changed

$$(2.50) \qquad M_{rc} = M_{rc} + \varepsilon X M_{rc}$$

where X is a Gaussian zero mean stochastic variable with unit variance, and $\varepsilon$ is the parameter that adjusts the strength of the perturbation. In this case $\varepsilon = 0.8$.

A new set of frequencies and mode shapes are then created by solving the eigenvalue problem once more using the new perturbed mass matrix, and finally 5 % Gaussian noise is added to the perturbed mode shapes in order to model a reasonable estimation noise.

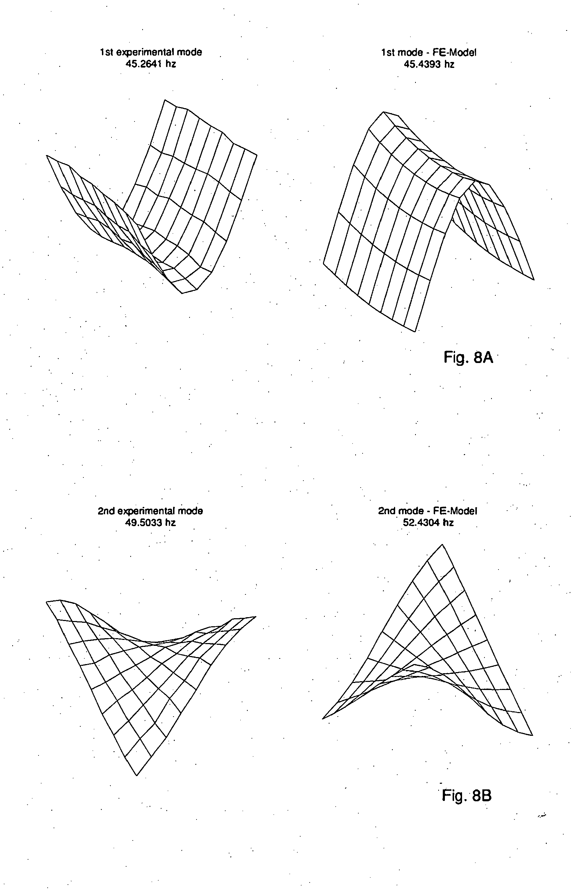

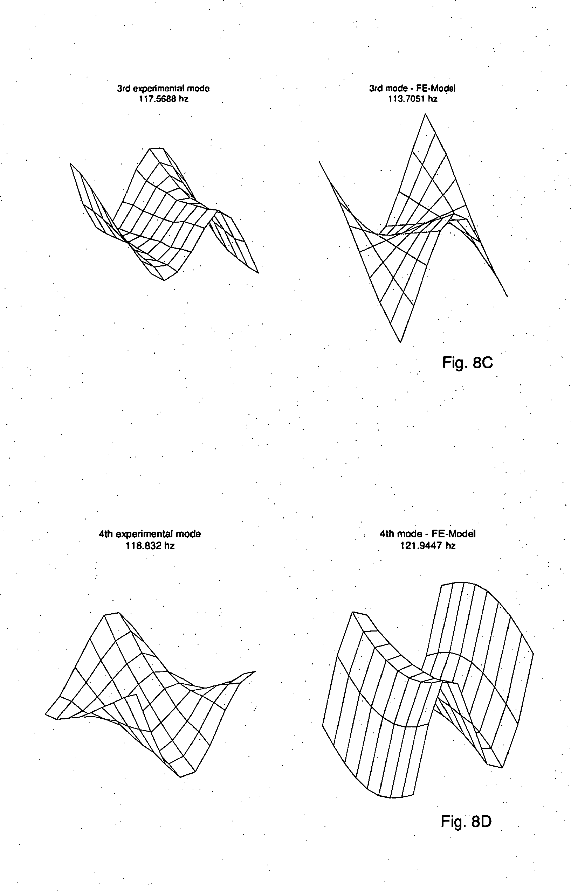

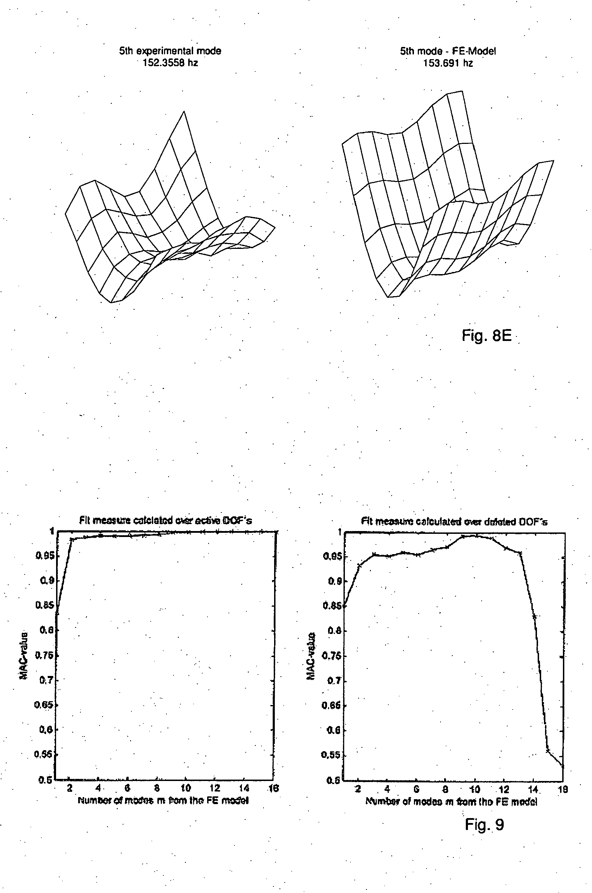

In this example, the unperturbed set of modes represents the FE modes, and the perturbed set of modes (with 5 % Gaussian noise) represent the experimental modes. The first five (non-rigid) modes are shown in Figure 8, natural frequencies are given in Table 1.

In this example mode no 4 in the experimental set is considered, that is the mode shape in Figure 8, top plot no 4 from the left with the natural frequency equal to 118.8 Hz. As it appears from Figure 8, the corresponding FE mode (primary mode) looks like being mode shape no 3 of the FE modes, this is bottom plot no 3 from the left in Figure 8. This is easily confirmed by calculating the MAC values between the considered experimental mode four and the set of FE modes. The MAC value between the considered experimental mode shape and the FE element mode shape no 3 is the maximum MAC value, the MAC value was found to MAC = 0.8349 calculated over the active DOF's.

In order to apply the LC principle, it is practical to establish a ranked list of FE modes to be included in the possible mode shape cluster matrices based on their distance measured in frequency to the primary mode. In the considered example, the ranked list was found to:

$$(2.51) \qquad (6, 7, 8, 5, 4, 9, 10, 3, 2, 1, 11, 12, 13, 14, 15, 16)$$

Here we are including the above mentioned three rigid body modes in the numbering, thus the first mode in the list, here denoted mode no 6, is shown as FE bending mode no 3 in Figure 8.

Step 2 is to form the different cluster mode shape matrices. They are easily created from the ranked list and expressed in the active (measured DOF used for optimization) DOF's only as

$$\mathbf{B}_{a,1} = \begin{bmatrix} \mathbf{b}_{6a} \end{bmatrix}$$
$$\mathbf{B}_{a,2} = \begin{bmatrix} \mathbf{b}_{6a} & \mathbf{b}_{7a} \end{bmatrix}$$
$$(2.52) \qquad \mathbf{B}_{a,3} = \begin{bmatrix} \mathbf{b}_{6a} & \mathbf{b}_{7a} & \mathbf{b}_{8a} \end{bmatrix}$$
$$\mathbf{B}_{a,4} = \begin{bmatrix} \mathbf{b}_{6a} & \mathbf{b}_{7a} & \mathbf{b}_{8a} & \mathbf{b}_{5a} \end{bmatrix}$$
$$\text{etc}$$

Step no 3 is to use Eq. (2.42-43) on all the cluster mode shape matrices and then find the optimal choice using a measure of best fit. Let the corresponding experimental mode (this is mode number 7 using similar numbering) be denoted **a**, then for the first cluster mode shape matrix using Eq. (2.35) we need to solve the equation in the active DOF's

$$(2.53) \qquad \mathbf{a}_a = \mathbf{B}_{a,1}\mathbf{t}_1$$

approximately such that the errors are minimum. In this case, since we only have one vector in this first cluster matrix, the matrix is just a vector, and the linear combination vector $\mathbf{t_1}$ is just a scalar, thus, we are considering the approximate scalar solution $t_1$ to the equation

$$(2.54) \qquad \mathbf{a}_a = \mathbf{b}_{a,6}t_1$$

The solution can in practice (the practical implementation of the above mentioned pseudo inverse) be found by multiplying from the left by $\mathbf{b}_{a,6}^T$. After this operation, the equation is reduced to a simple linear equation, and since we assume unit vectors we have

$$(2.55) \qquad \hat{t}_1 = \mathbf{b}_{a,6}^T\mathbf{a}_a /(\mathbf{b}_{a,6}^T\mathbf{b}_{a,6}) = MAC(\mathbf{b}_{a,6}, \mathbf{a}_a)^{1/2}$$

Therefore the best estimate using only one vector from the FE mode shape set is

$$(2.56) \qquad \hat{\mathbf{a}}_{a,1} = \mathbf{b}_{a,6}\hat{t}_1$$

And the measure of best fit according to Eq. (2.44) is then

$$(2.57) \qquad F_a(1) = \frac{(\hat{\mathbf{a}}_{a,1}^T\mathbf{a}_a)^2}{\hat{\mathbf{a}}_{a,1}^T\hat{\mathbf{a}}_{a,1}}$$

But since

$$(2.58) \qquad \hat{\mathbf{a}}_{a,1}^{T}\mathbf{a}_{a} = \mathbf{b}_{a,6}\hat{t}_{1}\mathbf{a}_{a} = MAC(\mathbf{b}_{a,6},\mathbf{a}_{a}); \quad \hat{\mathbf{a}}_{a,1}^{T}\hat{\mathbf{a}}_{a,1} = MAC(\mathbf{b}_{a,6},\mathbf{a}_{a})$$

We obtain the general result using Eq. (2.44)

$$(2.59) \qquad F_{a}(1) = MAC(\mathbf{b}_{a,6},\mathbf{a}_{a})$$

This establish the first value of the best fit measure $F_{a}(1) = 0.8349$ equal to the MAC value between the experimental and the corresponding FE mode shape calculated over the active DOF's.
If we use two vectors from the FE set, then we need the approximate solution to the equation

$$(2.60) \qquad \mathbf{a}_{a} = \mathbf{B}_{a,2}\mathbf{t}_{2}$$

In this case we multiply from the left by $\mathbf{B}_{a,2}^{T}$ and obtain

$$(2.61) \qquad \mathbf{B}_{a,2}^{T}\mathbf{a}_{a} = \mathbf{B}_{a,2}^{T}\mathbf{B}_{a,2}\mathbf{t}_{2}$$

The matrix $\mathbf{B}_{a,2}^{T}\mathbf{B}_{a,2}$ is a full rank 2x2 matrix, thus by inverting this matrix we obtain the solution

$$(2.62) \qquad \hat{\mathbf{t}}_{2} = (\mathbf{B}_{a,2}^{T}\mathbf{B}_{a,2})^{-1}\mathbf{B}_{a,2}^{T}\mathbf{a}_{a}$$

The matrix $(\mathbf{B}_{a,2}^{T}\mathbf{B}_{a,2})^{-1}\mathbf{B}_{a,2}^{T}$ is known as the Moore-Penrose pseudo inverse. We can now calculate the best estimate using two mode shape vectors from the FE mode shape set as

$$(2.63) \qquad \hat{\mathbf{a}}_{a,2} = \mathbf{B}_{a,2}\hat{\mathbf{t}}_{2}$$

And the next value of the best fit measure can now be calculated

$$(2.64) \qquad F_{a}(2) = \frac{(\hat{\mathbf{a}}_{a,2}^{T}\mathbf{a}_{a})^{2}}{\hat{\mathbf{a}}_{a,2}^{T}\hat{\mathbf{a}}_{a,m}}$$

This value is now increased to $F_{a}(2) = 0.9838$. Similar values can be calculated for more and more modes included in the cluster mode shape matrices, and the final result including up to 16 modes is found to

$$(2.65) \qquad F_{a}(m) = (0.8349,\ 0.9838,\ 0.9871,\ 0.9902,\ 0.9905,\ 0.9909,\ 0.9914,\ 0.9928,\ 0.9974,$$
$$0.9982,\ 0.9986,\ 0.9992,\ 0.9992,\ 0.9994,\ 0.9994,\ 1.0000)$$

As explained before, this best fit measure approaches unity when the number of modes approaches the number of active DOF's, therefore; this measure is not valuable for finding the optimal number of modes.
Similar calculations can be carried out for the measure $F_{d}(m)$ given by Eq. (2.45). The similar result including up to 16 modes is given by

$$(2.66) \qquad F_{d}(m) = (0.8507,\ 0.9316,\ 0.9537,\ 0.9510,\ 0.9582,\ 0.9545,\ 0.9640,\ 0.9704,\ 0.9925,$$
$$0.9928,\ 0.9871,\ 0.9689,\ 0.9577,\ 0.8314,\ 0.5602,\ 0.5304)$$

Again the first value corresponds to the MAC between the experimental and the corresponding FE mode, but now calculated over the deleted DOF's, thus the resulting value show a minor change compared to the previous value. The results of the two measures of best fit are shown in Figure 9.

As it appears from Figure 9, the measure of best fit $F_a(m)$ show an increasing tendency in the whole range from 1 to 16 modes included, whereas the measure of best fit $F_d(m)$ shows a clear optimum around $m$=9-11 modes included. From Eq. (2.66) we see that the optimum value is achieved for $m$ =10 FE modes included, and the fit measure at this point has a value of 0.9928. Thus the result of using the LC principle has increased the MAC between the experimental mode and the corresponding FE mode from 0.8507 to 0.9928. This improvement illustrates the importance of the principle.

### 6. Applications

The LC principle can be formulated as follows:

*for any perturbation of the mass or stiffness matrix, any perturbed mode shape can be expressed approximately* as a *linear combination* of a *limited set of unperturbed modes, the limited set of modes consisting of the corresponding unperturbed mode, and* a *limited number of unperturbed mode shapes around (in terms of frequency) the corresponding; unperturbed mode.*

In order to apply this principle it can be concluded from the preceding considerations that it is practical to take the following steps:

1. Establish a list of FE modes ranked after the distance to the primary FE mode measured in terms of frequency. For the example in Figure 8, the ranked list is the list of modes given by Eq. (2.51). The reason for this raking is that the primary mode comes first (this is FE mode no 6, because it is this FE mode that has the highest MAC value with the considered experimental mode), then as the second mode comes mode no 7, since this mode has the smallest distance to the primary mode, then comes mode no 8, since this mode has the second smallest distance to the primary mode etc., this continues until all modes from the FE model has been included in the list or until the number of modes is the same as the number of active DOF's.

2. Make a series of cluster mode shape matrices, the first cluster mode shape matrix $\mathbf{B}_1$ including only the mode shape from the primary FE mode (the first on the list), the second cluster mode shape matrix $\mathbf{B}_2$ including the mode shapes from the first two modes in the ranked list, the third cluster mode shape matrix $\mathbf{B}_3$ including the first three mode shapes in the ranked list etc., this continues until all mode shapes from the ranked list are included

3. For each of the cluster mode shape matrices find the corresponding estimates of the considered experimental mode shape according to Eq. (2.42-43) and then find the optimal choice using a measure of best fit where the fit is performed on some of the measurement points (the active DOF's), and the best fit is evaluated over the remaining measurement points (the deleted DOF's) according to Eq. (2.45)

As an alternative to the three steps mentioned above, one can also randomly choose different mode shape cluster matrices, for each of the mode shape cluster matrices use a best fit measure as described in step 3, and then pick the mode shape cluster matrix with the highest measure of the best fit.

One can also start with the primary FE mode, then try all possible cluster matrices consisting of the primary mode and one of the remaining FE modes and then pick the choice that gives the best fit, then add the third mode that again provides the best fit etc. and continue until all modes are included (number of modes equal to the number of DOF's). This is an indirect way - just based on the best fit - of reaching a list of modes that correspond to the ranked list described in step 1.

The LC principle has at least the following important applications

A. Experimental mode shapes are accurately modeled using a limited number of FE modes
B. Experimental modes are then known in all points known in the FE model
C. Experimental modes are smoothed, i.e. the noise is reduced
D. Deviations between the experimental mode shapes and the FE model mode shapes are divided into small and large deviations
E. A measured response can be accurately expanded to be known in all points of the FE model
F. Mode shapes obtained from operational modal analysis (OMA) can be scaled using the FE mass matrix

The points A-D can be directly derived from the preceding considerations. Point A) is a result of the LC principle described above. Point B) is a result of Eq. (2.46) since this equation can be directly expanded by taking the FE mode shapes to full size, Eq. (2.48). Point C) is a result of Eq. (2.47) since it is well known from estimation theory that this equation will always reduce noise if the number of DOF's is larger than the number of modes (if the matrix $B_{a,m}$ has more rows than columns). Point D) can be illustrated by looking at the deviation between the experimental mode shape **a** and the estimate of the experimental mode shape given by Eq. (2.46)

$$(2.67) \qquad \Delta\mathbf{a} = \mathbf{a} - \hat{\mathbf{a}}_{m_0}$$

Thus isolating the experimental mode shape and using Eq. (2.46)

$$(2.68) \qquad \mathbf{a} = \mathbf{B}_{m_0}\hat{\mathbf{t}}_{m_0} + \Delta\mathbf{a}$$

As it appears from the LC principle, all small perturbation of the mass and the stiffness matrix is covered by the linear transformation term $\mathbf{B}_{m_0}\hat{\mathbf{t}}_{m_0}$, thus the deviation vector $\Delta\mathbf{a}$ is a measure of noise and/or large changes of the mass and the stiffness matrix that cannot be considered as small perturbations.

Point E is of importance for operating deflection shapes (ODS). Writing Eq. (2.3) for the experimental system we obtain

$$(2.69) \qquad \mathbf{y}_a(t) = \mathbf{A}\mathbf{q}(t)$$

which can be solved for the modal coordinates

$$(2.70) \qquad \hat{\mathbf{q}}(t) = \mathbf{A}^+\mathbf{y}_a(t)$$

And the measured response can be estimated as

$$(2.71) \qquad \hat{\mathbf{y}}_a(t) = \mathbf{A}\hat{\mathbf{q}}(t)$$

Each of the experimental modes in A can now be modeled according to the LC principle, the corresponding transformation vectors can be found, and finally the set of experimental mode shapes can be estimated by (Eq. (2.40) in the active DOF's)

$$(2.72) \qquad \hat{\mathbf{A}} = \mathbf{B}_a\hat{\mathbf{T}}$$

The column vectors in the transformation matrix can be found as described above (optimizing each mode individually) or it can be estimated a little more roughly simply by

$$(2.73) \qquad \hat{\mathbf{T}} = \mathbf{B}_a^+\mathbf{A}$$

This estimate can now be inserted into Eq. (2.69)

$$(2.74) \qquad \hat{\mathbf{y}}_a(t) = \mathbf{B}_a\hat{\mathbf{T}}\hat{\mathbf{q}}(t)$$

And a "full blown" ODS can be obtained just by expanding the matrix **B** to full size

$$(2.75) \qquad \hat{\mathbf{y}}(t) = \mathbf{B}\hat{\mathbf{T}}\hat{\mathbf{q}}(t)$$

Point F) follows directly from the fact that the estimated mode shapes

$$(2.76) \qquad \mathbf{\hat{a}} = \mathbf{B}\mathbf{\hat{t}}$$

are known in all points. Without limitations we can assume that the estimated experimental mode shape has unit length, thus, we can estimate the modal mass using the mass matrix of the finite element model

$$(2.77) \qquad \mathbf{\hat{a}}^T \mathbf{M} \mathbf{\hat{a}} = m$$

and the corresponding scaled mode shape is simply given by

$$(2.78) \qquad \mathbf{\hat{\alpha}} = \mathbf{\hat{a}} / \sqrt{m}$$

Because then

$$(2.79) \qquad \mathbf{\hat{\alpha}}^T \mathbf{M} \mathbf{\hat{\alpha}} = 1$$

It is an important benefit that the FE model mass matrix can be used to scale the experimental modes, because, normally when mode shapes are estimated using OMA, mode shapes can only be scaled if several tests are performed introducing either different changes of masses and/or stiffness's in the considered structure, [11] (Khatibi et al 2009).

### Conclusions

A new local correspondence principle has been established relating experimental mode shapes to mode shapes from a FE model. The principle that is based on well-known sensitivity equations states that any experimental mode shapes can be approximated by a limited number of FE modes around the corresponding FE mode in a linear combination. The principle is true for both mass and stiffness deviations between the experiment and the model. However, it is limited to cases where mode shape deviations can be well described by sensitivity theory, i.e. the FE model can only be moderately wrong. It is shown that an optimal number of FE modes around the considered FE mode exist, and an example with rather large but well dispersed mass changes indicate that the so defined best approximation of the experimental mode shape is indeed a very good model of the observed mode shape. The principle has important applications for modeling and smoothing of experimental mode shapes, for their expansion to all DOF's known in the FE model, for quantifying small or large deviations between model and experiment and finally for using the mass matrix of the model to scale experimentally obtained mode shapes. Especially the option of estimating unknown DOF's is of value in cases where DOF's cannot be measured directly, for instance rotational DOF's and/or DOF's inside a body.

### References

[1] Allemang, R. J., Brown, D. L. (1982). A Correlation Coefficient for Modal Vector Analysis. International Modal Analysis Conference, SEM: 110-116.

[2] Autodesk (2011). "Autodesk Robot Structural Analysis Professional 2011." from http://usa.autodesk:com/.

[3] Avitabile, P., O'Callahan, J., Milani, J. and Dong-Rong Pan, E. (1989). System Model Development using Analytically Enhanced Experimental Data. 7th Int. Modal Analysis Conference (IMAC). Las Vegas, SEM.

[4] Brincker, R., Ventura, C.E. and Andersen, A. (2003). Why Output-Only Modal Testing is a Desirable Tool for a Wide Range of Practical Applications. 21 st Int. Modal Analysis Conference (IMAC). Kissimmee, Floria, SEM.

[5] D'Ambrogio, W. and A. Fregolent (2003). "Higher-order MAC for the correlation of close and multiple modes." Mechanical Systems and Signal Processing 17(3): 599-610.

[6] Friswell, M.I. and Mottershead, J.E. (1995). Finite Element Updating in Structural Dynamics, Kluver Academic Publishers.

[7] Goge, D. and M. Link (2003). "Assessment of computational model updating procedures with regard to model validation." Aerospace Science and Technology 7(1): 47-61.

[8] Gregory, D. L. a. S. D. O. (1989). "Experimental Results of the IES Modal Plate." The journal of Environmental Sciences(Nov/Dec): 15-21.

[9] Heylen, W., Lammens, S. and Sas, P. (1997). Modal Analysis Theory and Testing, Katholieke Universiteit Leuven, Faculty of Eng., Dept. of Mech. Eng..

[10] Jaishi, B. and W. X. Ren (2004). Objective functions for finite element model updating in structural dynamics.

[11] Khatibi, M. M., Ashory, M.R. and Malekjafarian, A. (2009). Scaling of Mode Shapes Using Mass-Stiffness Strategy. 3rd International Modal Analysis Conference (IOMAC). Ancona, Italy, IOMAC.

[12] Lipkens, J. a. V., U. (1988). the use of Smoothing Techniques for Structural Modification Applications. International Modal Analysis Conference (MAC). D. J. DeMichele. Kissimee, Florida, USA, SEM: 1048-1052.

[13] Nelson, R. B. (1976). "SIMPLIFIED CALCULATION OF EIGENVECTOR DERIVATIVES." Aiaa Journal 14(9): 1201-1205.

[14] O'Callahan, J., Avitabile, P. andRiemer, R. (1989). System Equivalent Reduction Expansion Process. 7th Int. Modal Analysis Conference (IMAC). Las Vegas, SEM.

[15] Reynders, E., A. Teughels, et al. (2010). "Finite element model updating and structural damage identification using OMAX data." Mechanical Systems and Signal Processing 24(5): 1306-1323.

[16] Sestieri A., D'Ambrogio W. (2001), "Structural Dynamic Modification", Encyclopedia of Vibration, Academis Press, London.

[17] Teughels, A. and G. De Roeck (2004). "Structural damage identification of the highway bridge Z24 by FE model updating." Journal of Sound and Vibration 278(3): 589-610.

[18] Wang, H., A. Q. Li, et al. (2010). "Progressive finite element model calibration of a long-span suspension bridge based on ambient vibration and static measurements." Engineering Structures 32(9): 2546-2556.

**Claims**

1. A method for improving determination of mode shapes for a mechanical structure where each mode shape is a vector that consists of a number of components and each vector corresponds to a natural frequency of the structure where the method is based on

    • Measurements performed on the structure using signals from a limited number of sensors such as accelerometers placed on the structure defining the number of components of each of the mode shape vectors, where the measured signals are used to determine a number of mode shapes $\mathbf{a}_1, \mathbf{a}_2 \cdots$, which are listed according to natural frequency starting with the lowest natural frequency.
    • Determination of a number of mode shapes $\mathbf{b}_1, \mathbf{b}_2 \ldots$, based on a numerical model of the structure, defining a number of components of each mode shape b in the numerical model, each of which corresponding to a mode shape a calculated from the measurements, wherein the number of components of each mode shape **b** in the numerical model is larger than the number of sensors. The mode shapes $\mathbf{b}_1, \mathbf{b}_2 \cdots$ are listed according to natural frequency starting with the lowest natural frequency.
    • Determination of a set of modified mode shapes $\hat{a}_1, \hat{a}_2 \cdots$ for improving the accuracy of the mode shapes $a_1, a_2 \ldots$ by removing influence from random noise and measurement errors, where each of the modified mode shapes **â** is an improvement of the mode shape a corresponding to the mode shape b in the numerical model, where each of the modified mode shapes **â** is defined as the best fit of a linear combination of the mode shapes $\mathbf{b}_1, \mathbf{b}_2 \ldots$ but reduced to the set of components corresponding to components in the measured signals, where a

24

value expressing the difference between the mode shapes a calculated from the measurements and the corresponding modified mode shapes **â** is minimized.

**Characterized in that** the linear combination consists of a limited number of the mode shapes $\mathbf{b}_1, \mathbf{b}_2$ ... with natural frequencies around the natural frequency of the corresponding mode shape **b**.

2. A method in according to claim 1 **characterized in that**

- the mode shapes included in the linear combination are defined by a sequence of the mode shapes of the numerical model that starts with the corresponding mode shape **b** and where the remaining mode shapes are arranged in a sequence after the distance to the corresponding mode shape measured in term of frequency such that the mode shape with smallest distance measured in term of frequency to the corresponding mode shape has highest rank in the sequence
- the number of mode shapes from this list that is to be included in the linear combination is determined by evaluating the fit quality that is a measure of the difference between the mode shape **a** and **a** calculated based on the vector components not included in the fitting algorithm and adjusting the number of included modes so that the fit quality is maximized.

3. A method in according to claim 1 **characterized in that** the mode shapes included in the linear combination are defined by a sequence of the mode shapes of the numerical model that starts with the corresponding mode shape **b** and where the remaining mode shapes are arranged in a sequence according to maximum fitting measure increment, thus, the mode shape that comes first in the sequence gives the highest increment of the fitting quality when added to the linear combination, where the fitting quality is a measure of the difference between the mode shape **a** and **â** calculated based on the vectors components not included in the fitting algorithm and adjusting the number of included modes so that the fit quality is maximized.

4. A method in according to one or more of claims 1-3 **characterized in that** the modified shapes $\hat{\mathbf{a}}_1, \hat{\mathbf{a}}_2$... that in the first place have been estimated in the set of components corresponding to components in the measured signals, are expanded to all components known in the numerical model by including all components of the mode shapes $\mathbf{b}_1, \mathbf{b}_2$... in the linear combination.

**Patentansprüche**

1. Verfahren zur Verbesserung der Bestimmung von Schwingungsformen einer mechanischen Struktur, wobei jede Schwingungsform ein Vektor ist, der aus einer Anzahl an Komponenten besteht, und jeder Vektor einer Eigenfrequenz der Struktur entspricht, wobei das Verfahren basiert auf

- Messungen, die an der Struktur unter Verwendung von Signalen von einer begrenzten Anzahl an Sensoren durchgeführt werden, wie an der Struktur angebrachten Beschleunigungsaufnehmern, die die Anzahl der Komponenten jeder der Schwingungsformvektoren festlegen, wobei die Messsignale zur Bestimmung einer Anzahl an Schwingungsformen $\mathbf{a}_i, \mathbf{a}_2$... verwendet werden, die beginnend mit der niedrigsten Eigenfrequenz gemäß der Eigenfrequenz aufgelistet werden.
- Bestimmung einer Anzahl an Schwingungsformen $\mathbf{b}_1, \mathbf{b}_2$... auf der Grundlage eines numerischen Modells der Struktur zur Festlegung einer Anzahl an Komponenten jeder Schwingungsform **b** in dem numerischen Modell, wobei jede einer Schwingungsform **a** entspricht, die anhand der Messungen ermittelt wurde, wobei die Anzahl an Komponenten jeder Schwingungsform **b** in dem numerischen Modell größer ist als die Anzahl an Sensoren. Die Schwingungsformen $\mathbf{b}_1, \mathbf{b}_2$... werden beginnend mit der niedrigsten Eigenfrequenz gemäß der Eigenfrequenz aufgelistet.
- Bestimmung eines Satzes modifizierter Schwingungsformen $\hat{\mathbf{a}}_1, \hat{\mathbf{a}}_2$... zur Verbesserung der Genauigkeit der Schwingungsformen $\mathbf{a}_1, \mathbf{a}_2$... durch Entfernung des Einflusses von Zufallsrauschen und Messfehlern, wobei jede der modifizierten Schwingungsformen **â** eine Verbesserung der Schwingungsform **a** darstellt, die der Schwingungsform **b** in dem numerischen Modell entspricht, wobei jede der modifizierten Schwingungsformen **â** als beste Übereinstimmung einer linearen Kombination der Schwingungsformen $\mathbf{b}_1, \mathbf{b}_2$... festgelegt ist, allerdings reduziert auf den Satz Komponenten, die den Komponenten der Messsignale entsprechen, wobei ein Wert, der den Unterschied zwischen den anhand der Messungen berechneten Schwingungsformen **a** und den entsprechenden modifizierten Schwingungsformen **â** ausdrückt, minimiert ist.

**Dadurch gekennzeichnet, dass** die lineare Kombination aus einer begrenzten Anzahl der Schwingungsformen $b_1, b_2$... mit Eigenfrequenzen um die Eigenfrequenz der entsprechenden Schwingungsform **b** besteht.

2. Verfahren nach Anspruch 1, **dadurch gekennzeichnet, dass**

   • die in die lineare Kombination eingeschlossenen Schwingungsformen durch eine Sequenz der Schwingungsformen des numerischen Modells definiert sind, die mit der entsprechenden Schwingungsform **b** beginnt, und wobei die restlichen Schwingungsformen in einer Sequenz gemäß dem frequenzbezogen gemessenen Abstand zu der entsprechenden Schwingungsform derart angeordnet sind, dass die Schwingungsform mit dem geringsten frequenzbezogen gemessenen Abstand zu der entsprechenden Schwingungsform die höchste Rangstufe in der Sequenz aufweist
   • die Anzahl an Schwingungsformen aus der Liste, die in die lineare Kombination eingeschlossen werden sollen, durch Beurteilung der Übereinstimmungsqualität, die ein Maß des Unterschieds zwischen der Schwingungsform **a** und **â** ist, welche auf der Grundlage der nicht in den Übereinstimmungsalgorithmus eingeschlossenen Vektorkomponenten berechnet ist, und durch Anpassung der Anzahl an eingeschlossenen Schwingungen bestimmt wird, sodass die Übereinstimmungsqualität maximiert ist.

3. Verfahren nach Anspruch 1, **dadurch gekennzeichnet, dass** die in die lineare Kombination eingeschlossenen Schwingungsformen durch eine Sequenz der Schwingungsformen des numerischen Modells definiert sind, das mit der entsprechenden Schwingungsform **b** beginnt, und wobei die restlichen Schwingungsformen in einer Sequenz mit einem Anstieg gemäß dem maximalen Übereinstimmungsmaß angeordnet sind, sodass die erste Schwingungsform der Sequenz bei Addition zur linearen Kombination den höchsten Anstieg der Übereinstimmungsqualität ergibt, wobei die Übereinstimmungsqualität ein Maß des Unterschieds zwischen der Schwingungsform **a** und **â** ist, welche auf der Grundlage der nicht in den Übereinstimmungsalgorithmus eingeschlossenen Vektorkomponenten berechnet ist, und durch Anpassung der Anzahl an eingeschlossenen Schwingungen, sodass die Übereinstimmungsqualität maximiert ist.

4. Verfahren nach einem oder mehreren der Ansprüche 1-3, **dadurch gekennzeichnet, dass** die modifizierten Formen $â_1, â_2$..., die zunächst in dem Satz Komponenten, der den Komponenten der Messsignale entsprechen, geschätzt wurden, durch Einschließen aller Komponenten der Schwingungsformen $b_1, b_2$... der linearen Kombination auf alle in dem numerischen Modell bekannten Komponenten erweitert werden.

**Revendications**

1. Procédé d'amélioration de la détermination de formes de mode pour une structure mécanique, dans lequel chaque forme de mode est un vecteur qui est constitué d'un certain nombre de composants et chaque vecteur correspond à une fréquence naturelle de la structure, le procédé étant basé sur

   • Des mesures effectuées sur la structure au moyen de signaux provenant d'un nombre limité de capteurs tels que des accéléromètres placés sur la structure définissant le nombre de composants de chacun des vecteurs de forme de mode, les signaux mesurés étant utilisés pour déterminer un nombre de formes de mode $a_1, a_2$..., qui sont récapitulés en fonction de la fréquence naturelle en commençant par la fréquence naturelle la plus basse.
   • La détermination d'un nombre de formes de mode $b_1, b_2$..., sur la base d'un modèle numérique de la structure, définissant un nombre de composants de chaque forme de mode **b** dans le modèle numérique, chacun correspondant à une forme de mode **a** calculée à partir des mesures, le nombre de composants de chaque forme de mode **b** dans le modèle numérique étant supérieur au nombre de capteurs. Les formes de mode $b_1, b_2$... sont énumérées en fonction de la fréquence naturelle en commençant par la fréquence naturelle la plus basse.
   • La détermination d'un ensemble de formes de mode modifiées $â_1, â_2$... pour améliorer la précision des formes de mode $a_1, a_2$... par la suppression de l'influence du bruit aléatoire et des erreurs de mesure, chacune des formes de mode modifiées **â** étant une amélioration de la forme de mode **a** correspondant à la forme de mode **b** dans le modèle numérique, chacune des formes de mode modifiées **â** étant définie comme la meilleure adaptation d'une combinaison linéaire des formes de mode $b_1, b_2$... mais réduite à l'ensemble des composants correspondant aux composants dans les signaux mesurés, dans lequel une valeur exprimant la différence entre les formes de mode **a** calculée à partir des mesures et des formes de mode modifiées correspondantes **â** est minimisée.

   **Caractérisé en ce que** la combinaison linéaire est constituée d'un nombre limité des formes de mode $b_1, b_2$...

comprenant les fréquences naturelles autour de la fréquence naturelle de la forme de mode correspondante **b**.

2. Procédé selon la revendication 1, **caractérisé en ce que**

   • les formes de mode incluses dans la combinaison linéaire sont définies par une séquence des formes de mode du modèle numérique qui commence par la forme de mode correspondante **b** et dans lequel les formes de mode restantes sont disposées en séquence après la distance à la forme de mode correspondante mesurée en termes de fréquence, de sorte que la forme de mode présentant la plus petite distance mesurée en termes de fréquence à la forme de mode correspondante ait le rang le plus élevé dans la séquence
   • le nombre de formes de mode de cette liste qui doit être inclus dans la combinaison linéaire est déterminé par l'évaluation de la qualité d'adaptation qui est une mesure de la différence entre la forme de mode **a** et **â** calculée sur la base des composants de vecteur non inclus dans l'algorithme d'adaptation et par l'ajustement du nombre de modes inclus de sorte que la qualité d'adaptation soit maximisée.

3. Procédé selon la revendication 1 **caractérisé en ce que** les formes de mode incluses dans la combinaison linéaire sont définies par une séquence des formes de mode du modèle numérique qui commence par la forme de mode correspondante **b** et dans lequel les formes de mode restantes sont disposées en séquence en fonction d'un incrément de mesure d'adaptation maximal, ainsi la forme de mode qui vient en premier dans la séquence donne l'incrément le plus élevé de la qualité d'adaptation ajouté à la combinaison linéaire, dans lequel la qualité d'adaptation est une mesure de la différence entre la forme de mode **a** et **â** calculée sur la base des composants des vecteurs non inclus dans l'algorithme d'adaptation et par l'ajustement du nombre de modes inclus de sorte que la qualité d'adaptation soit maximisée.

4. Procédé selon au moins l'une des revendications 1 à 3 **caractérisé en ce que** les formes modifiées $\hat{a}_1, \hat{a}_2$... qui ont été estimées au début dans l'ensemble de composants correspondant aux composants des signaux mesurés sont étendues à tous les composants connus dans le modèle numérique par inclusion de tous les composants des formes de mode $\mathbf{b}_1, \mathbf{b}_2$... dans la combinaison linéaire.

Fig. 1

Fig. 2

Fig. 3

Fig. 4

Fig. 5A

Fig. 5B

Fig. 6A

Fig. 6B

Fig. 7

1st experimental mode
45.2641 hz

1st mode - FE-Model
45.4393 hz

Fig. 8A

2nd experimental mode
49.5033 hz

2nd mode - FE-Model
52.4304 hz

Fig. 8B

3rd experimental mode
117.5688 hz

3rd mode - FE-Model
113.7051 hz

Fig. 8C

4th experimental mode
118.832 hz

4th mode - FE-Model
121.9447 hz

Fig. 8D

5th experimental mode
152.3558 hz

5th mode - FE-Model
153.691 hz

Fig. 8E

Fit measure calculated over active DOF's

Fit measure calculated over deleted DOF's

MAC-value

Number of modes m from the FE model

MAC-value

Number of modes m from the FE model

Fig. 9

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- WO 0133182 A1

### Non-patent literature cited in the description

- **A. BUTLAND et al.** A reduced order, test verified component mode synthesis approach for system modeling applications. *Mechanical Systems and Signal Processing, London, GB,* May 2010, vol. 24 (4), ISSN 0888-3270, 904-921
- *Autodesk Robot Structural Analysis Professional 2011,* 2011
- **ALLEMANG, R. J. ; BROWN, D. L.** A Correlation Coefficient for Modal Vector Analysis. *International Modal Analysis Conference,* 1982
- Autodesk Robot Structural Analysis Professional 2011. *Autodesk,* 2011, http://usa.autodesk:com/
- **AVITABILE, P. ; O'CALLAHAN, J. ; MILANI, J. ; DONG-RONG PAN, E.** System Model Development using Analytically Enhanced Experimental Data. *7th Int. Modal Analysis Conference (IMAC),* 1989
- **BRINCKER, R. ; VENTURA, C.E. ; ANDERSEN, A.** Why Output-Only Modal Testing is a Desirable Tool for a Wide Range of Practical Applications. *21 st Int. Modal Analysis Conference (IMAC),* 2003
- **D'AMBROGIO, W. ; A. FREGOLENT.** Higher-order MAC for the correlation of close and multiple modes. *Mechanical Systems and Signal Processing,* 2003, vol. 17 (3), 599-610
- **FRISWELL, M.I. ; MOTTERSHEAD, J.E.** Finite Element Updating in Structural Dynamics. Kluver Academic Publishers, 1995
- **GOGE, D. ; M. LINK.** Assessment of computational model updating procedures with regard to model validation. *Aerospace Science and Technology,* 2003, vol. 7 (1), 47-61
- **GREGORY, D. L. A. S. D. O.** Experimental Results of the IES Modal Plate. *The journal of Environmental Sciences(Nov/Dec),* 1989, 15-21
- **HEYLEN, W. ; LAMMENS, S. ; SAS, P.** Modal Analysis Theory and Testing. Katholieke Universiteit Leuven, Faculty of Eng., Dept. of Mech. Eng, 1997
- **JAISHI, B. ; W. X. REN.** *Objective functions for finite element model updating in structural dynamics,* 2004
- **KHATIBI, M. M. ; ASHORY, M.R. ; MALEKJAFARIAN, A.** Scaling of Mode Shapes Using Mass-Stiffness Strategy. *3rd International Modal Analysis Conference (IOMAC),* 2009
- **LIPKENS, J. A. V., U.** the use of Smoothing Techniques for Structural Modification Applications. *International Modal Analysis Conference (MAC),* 1988
- **NELSON, R. B.** SIMPLIFIED CALCULATION OF EIGENVECTOR DERIVATIVES. *Aiaa Journal,* 1976, vol. 14 (9), 1201-1205
- **O'CALLAHAN, J. ; AVITABILE, P. ; RIEMER, R.** System Equivalent Reduction Expansion Process. *7th Int. Modal Analysis Conference (IMAC),* 1989
- **REYNDERS, E. ; A. TEUGHELS et al.** Finite element model updating and structural damage identification using OMAX data. *Mechanical Systems and Signal Processing,* 2010, vol. 24 (5), 1306-1323
- Structural Dynamic Modification. **SESTIERI A. ; D'AMBROGIO W.** Encyclopedia of Vibration. Academis Press, 2001
- **TEUGHELS, A. ; G. DE ROECK.** Structural damage identification of the highway bridge Z24 by FE model updating. *Journal of Sound and Vibration,* 2004, vol. 278 (3), 589-610
- **WANG, H. ; A. Q. LI et al.** Progressive finite element model calibration of a long-span suspension bridge based on ambient vibration and static measurements. *Engineering Structures,* 2010, vol. 32 (9), 2546-2556